# EUROPEAN PATENT APPLICATION

(11) **EP 4 794 491 A1**
(43) Date of publication of application: **19.08.2026**
(21) Application number: 25760781.2
(22) Date of filing: 14.02.2025
(51) Int. Cl.: H10F 77/20

(54) **BACK CONTACT SOLAR CELL AND MANUFACTURING METHOD THEREFOR**

(30) Priority: 01.03.2024 CN 202410232844
(71) Applicant: Longi Green Energy Technology Co., Ltd., Xi'an, Shaanxi 710100 (CN)
(72) Inventor: LI, Zhenguo, Shaanxi 710100 (CN); TONG, Hongbo, Shaanxi 710100 (CN); LIU, Qingping, Shaanxi 710100 (CN); DONG, Guangbin, Shaanxi 710100 (CN); DING, Chao, Shaanxi 710100 (CN); ZHANG, Hongchao, Shaanxi 710100 (CN); CHEN, Chen, Shaanxi 710100 (CN); XU, Xinxing, Shaanxi 710100 (CN); WANG, Yanzeng, Shaanxi 710100 (CN)
(74) Representative: Pfenning, Meinig & Partner mbB
(86) International application number: PCT/CN2025/077373
(87) International publication number: WO 2025/180238

(57) **Abstract**

The present application discloses a back contact solar cell and a manufacturing method therefor, and relates to the field of photovoltaic technologies, to increase the light utilization on a back surface of the back contact solar cell, which enhances the photoelectric conversion efficiency and yield of the back contact solar cell. The back contact solar cell includes: a silicon substrate, and a first doped semiconductor layer and a second doped semiconductor layer that are alternately distributed in a spaced manner on a back surface of the silicon substrate. On the back surface of the silicon substrate, regions corresponding to the first doped semiconductor layer are first regions; regions corresponding to the second doped semiconductor layer are second regions; and regions between the first regions and second regions adjacent to the first regions are spacer regions. Surfaces of the second regions are recessed toward an interior of the silicon substrate relative to surfaces of the first regions. Surfaces of the spacer regions are recessed toward the interior of the silicon substrate relative to the surfaces of the second regions. Bottom surfaces of the spacer regions, first side surfaces of the spacer regions close to the first regions, and second side surfaces of the spacer regions close to the second regions are textured surfaces.

## Description

### TECHNICAL FIELD

The present application relates to the field of photovoltaic technology, and particularly relates to a back contact solar cell and a manufacturing method therefor.

### BACKGROUND

A back contact solar cell is a solar cell in which no electrode is arranged on a light receiving surface of a cell and positive and negative electrodes are both arranged on a back surface of the cell, so that blocking of the electrodes to the cell can be reduced, a short-circuit current of the cell can be increased, and the energy conversion efficiency of the cell can be enhanced.

However, the light utilization on the back surface of the existing back contact solar cell is reduced, which does not help enhance the photoelectric conversion efficiency of the back contact solar cell. In addition, the back contact solar cell has a relatively high alignment requirement for each process stage because doped regions (i.e. n-type and p-type regions) of opposite conductivity types are both located on the same side.

### SUMMARY

An objective of the present application is to provide a back contact solar cell and a manufacturing method therefor, to increase the light utilization on the back surface of a back contact solar cell, which helps enhance the photoelectric conversion efficiency and yield of the back contact solar cell.

To achieve the foregoing objective, according to a first aspect, the present application provides a back contact solar cell. The back contact solar cell includes: a silicon substrate, and a first doped semiconductor layer and a second doped semiconductor layer that are alternately distributed in a spaced manner on a back surface of the silicon substrate. A conductivity type of the first doped semiconductor layer is opposite to a conductivity type of the second doped semiconductor layer. On the back surface of the silicon substrate, regions corresponding to the first doped semiconductor layer are first regions; regions corresponding to the second doped semiconductor layer are second regions; and regions between the first regions and second regions adjacent to the first regions are spacer regions. Surfaces of the second regions are recessed toward an interior of the silicon substrate relative to surfaces of the first regions. Surfaces of the spacer regions are recessed toward the interior of the silicon substrate relative to the surfaces of the second regions. Bottom surfaces of the spacer regions, first side surfaces of the spacer regions close to the first regions, and second side surfaces of the spacer regions close to the second regions are textured surfaces.

By the adoption of the foregoing technical solution, in the back contact solar cell provided in the present application, the first doped semiconductor layer and the second doped semiconductor layer that have opposite conductivity types are alternately distributed in the spaced manner on the back surface of the silicon substrate. Based on this, the spacer regions on the back surface of the silicon substrate can separate the first doped semiconductor layer formed in the first regions from the second doped semiconductor layer formed in the second regions, to reduce the carrier recombination rate at lateral interfaces of the first doped semiconductor layer and the second doped semiconductor layer. This helps enhance the photoelectric conversion efficiency of the back contact solar cell. In addition, the surfaces of the second regions are recessed toward the interior of the silicon substrate relative to the surfaces of the first regions, and the surfaces of the spacer regions are recessed toward the interior of the silicon substrate relative to the surfaces of the second regions. It indicates that in an actual manufacturing process, after the first doped semiconductor layer covering the back surface as a whole layer are formed, the portions of the first doped semiconductor layer located in the second regions and the spacer regions are completely removed. Moreover, after selective etching on the first doped semiconductor layer is implemented, and the second doped semiconductor layer are deposited as a whole layer, the portions of the second doped semiconductor layer located on the first doped semiconductor layer and in the spacer regions are completely removed, to prevent leakage caused by residuals still existing on surfaces of corresponding regions after the first doped semiconductor layer and/or the second doped semiconductor layer are selectively etched. Meanwhile, when the surfaces of the second regions are recessed toward the interior of the silicon substrate relative to the surfaces of the first regions, it also helps at least partially stagger, in a thickness direction of the silicon substrate, the first doped semiconductor layer and the second doped semiconductor layer that are jointly located on the back surface of the silicon substrate and have the opposite conductivity types, thereby further lowering a risk of electric leakage of the back surface and enhancing the electrical reliability of the back contact solar cell.

In addition, in the back contact solar cell provided in the present application, the bottom surfaces of the spacer regions are the textured surfaces, and the first side surfaces of the spacer regions close to the first regions and the second side surfaces of the spacer regions close to the second regions are also textured surfaces. Compared with a flat surface, the textured surface has a relatively good light trapping effect with its concave-convex surface feature, and can reduce the reflectivity of the bottom surfaces, the first side surfaces, and the second side surfaces of the spacer regions. In addition, textured structures are formed in the regions of the first side surfaces and the regions of the second side surfaces, that is, the regions of the first side surfaces and the regions of the second side surfaces have a relatively large specific surface area and a light trapping effect. In this case, compared with the existing back contact solar cell in which the first side surfaces and the second side surfaces are flat surfaces, the back contact solar cell provided in the present application helps refract more light from the first side surfaces and the second side surfaces into the silicon substrate and cause the silicon substrate to use the light, thereby helping enhance the photoelectric conversion efficiency of the back contact solar cell.

In a possible implementation, the first side surfaces and the second side surfaces are obliquely disposed relative to a horizontal plane, so that a cross-sectional area of the spacer regions gradually increases in a direction from a light receiving surface to the back surface.

By the adoption of the foregoing technical solution, when the cross-sectional area of one side of the spacer regions close to the light receiving surface is smaller than the cross-sectional area of one side of the spacer regions close to the back surface, it helps increase a distance between the first doped semiconductor layer and the second doped semiconductor layer having the opposite conductivity types, to lower a risk of electric leakage on the back surface of the back contact solar cell and ensure that the back contact solar cell has relatively high electrical reliability. In addition, compared with the first side surfaces and the second side surfaces being both vertically disposed relative to the horizontal plane, that the first side surfaces and the second side surfaces are respectively obliquely disposed relative to the horizontal plane can also increase an area ratio of orthographic projections of both the first side surfaces and the second side surfaces on the back surface. This can further reduce the reflectivity of the back surface, so that more light can enter the silicon substrate from the back surface of the back contact solar cell under the light trapping effect of both the first side surfaces and the second side surfaces, thereby helping enhance the photoelectric conversion efficiency of the back contact solar cell.

In a possible implementation, angles respectively between the first side surfaces of the spacer regions and the horizontal plane and between the second side surfaces of the spacer regions and the horizontal plane are greater than or equal to 52° and less than or equal to 58°.

By the adoption of the foregoing technical solution, when the angles respectively between the first side surfaces and the horizontal plane and between the second side surfaces and the horizontal plane are within the foregoing ranges, it can prevent such a phenomenon that the effect of reducing the reflectivity of the back surface by using the first side surfaces and the second side surfaces is not significant because the areas of orthographic projections of both the first side surfaces and the second side surfaces on the back surface are relatively small due to relatively large angles, to ensure that the back surface of the back contact solar cell has relatively high light utilization. In addition, such a phenomenon that a depth of the surfaces of the spacer regions that are recessed toward the interior of the silicon substrate relative to the surfaces of the second regions is relatively small due to relatively small angles, to ensure that after the second doped semiconductor layer deposited as a whole layer are selectively etched, the portions of the second doped semiconductor layer located in the spacer regions and on the first doped semiconductor layer are completely removed to prevent leakage, and ensure that the back contact solar cell has relatively high electrical reliability.

In a possible implementation, a morphology of textured structures on the first side surfaces and a morphology of textured structures on the second side surfaces are different from a morphology of textured structures on the bottom surfaces of the spacer regions.

By the adoption of the foregoing technical solution, the bottom surfaces of the spacer regions are approximately parallel to the horizontal plane. In addition, since the bottom surfaces of the spacer regions are recessed toward the interior of the silicon substrate relative to the surfaces of the second regions, the first side surfaces of the spacer regions close to the first regions and the second side surfaces of the spacer regions close to the second regions are respectively obliquely disposed or vertically disposed relative to the horizontal plane. It can be seen that a relative positional relationship between the bottom surfaces of the spacer regions and the horizontal plane is different from relative positional relationships respectively between the first side surfaces and the horizontal plane, and between the second side surfaces and the horizontal plane. Therefore, a surface crystal orientation of the bottom surfaces of the spacer regions is different from a surface crystal orientation of the first side surfaces and a surface crystal orientation of the second side surfaces respectively. It can be understood that performing texturing treatment on the surfaces to form textured structures is implemented based on different etching rates of an etching agent on portions of the silicon substrate in different crystal orientations. Therefore, when the surface crystal orientation of the bottom surfaces of the spacer regions is different respectively from the surface crystal orientation of the first side surfaces and the surface crystal orientation of the second side surfaces, a morphology of the textured structures formed on the first side surfaces and a morphology of textured structures on the second side surfaces by using the etching agent are both different from the morphology of the textured structures formed on the bottom surfaces of the spacer regions. In this case, in the back contact solar cell provided in the present application, in a case that the morphology of the textured structures on the first side surfaces and the morphology of the textured structures on the second side surfaces are both different from the morphology of the textured structures on the bottom surfaces of the spacer regions, an additional operation does not need to be performed to form textured structures having approximately the same morphology on the bottom surfaces, the first side surfaces, and the second side surfaces of the spacer regions, thereby helping simplify the manufacturing process of the back contact solar cell while lowering the manufacturing difficulty of the back contact solar cell.

In a possible implementation, a longitudinal cross section of the first side surfaces and a longitudinal cross section of the second side surfaces are zigzag-shaped. In this case, a zigzag shape has a plurality of sharp-corner morphologies. Based on this, in a case that other factors are the same, compared with a smoothly transitional morphology such as an arc shape or a curve, the zigzag morphology has a relatively high coarseness. Therefore, when the longitudinal cross section of the first side surfaces and the longitudinal cross section of the second side surfaces are zigzag-shaped, it helps cause the first side surfaces and the second side surfaces to have relatively high coarseness, thereby further helping further reduce the reflectivity of the first side surfaces and the reflectivity of the second side surfaces and further enhance the light utilization of the back contact solar cell.

In a possible implementation, the textured structures on the first side surfaces and the textured structures on the second side surfaces are triangular-prism-like structures. A beneficial effect in this case is similar to the beneficial effect when the longitudinal cross section of the first side surfaces and the longitudinal cross section of the second side surfaces are zigzag-shaped, and details are not described herein again. In addition, the triangular-prism-like structure is a polyhedral structure, which helps enlarge a specific surface area of the first side surfaces and a specific surface area of the second side surfaces, and further reduces the reflectivity of the first side surfaces and the reflectivity of the second side surfaces.

In a possible implementation, the textured structures on the bottom surfaces of the spacer regions are pyramid-like structures.

By the adoption of the foregoing technical solution, the pyramid-like structure is a pentahedron-like structure. Compared with a textured structure having a relatively small quantity of surfaces, such as a V-shaped groove, when the textured structures on the bottom surfaces of the spacer regions are the pyramid-like structure, it helps enlarge a specific surface area of the bottom surfaces of the spacer regions. In addition, surfaces of the textured structures on the bottom surfaces of the spacer regions have recesses, that is, the surfaces of the textured structures are uneven. This can further increase the coarseness of the bottom surfaces of the spacer regions, thereby helping reduce the reflectivity of the spacer regions.

In a possible implementation, a depth of the surfaces of the second regions that are recessed toward the interior of the silicon substrate relative to the surfaces of the first regions is greater than or equal to 0.5 µm and less than or equal to 3 µm.

By the adoption of the foregoing technical solution, when the depth of the surfaces of the second regions that are recessed toward the interior of the silicon substrate is within the foregoing range, it can prevent a small degree of staggering, in the thickness direction of the silicon substrate, between the first doped semiconductor layer and the second doped semiconductor layer that are jointly located on the back surface of the silicon substrate and have the opposite conductivity types due to a relatively small depth of the surfaces of the second regions that are recessed toward the interior of the silicon substrate, to further lower the risk of electric leakage of the back surface. In addition, the spacer regions are recessed toward the silicon substrate relative to the second regions. That is, compared with the second regions, the depth of the spacer regions recessed toward the interior of the silicon substrate is larger. Therefore, when the depth of the surfaces of the second regions that are recessed toward the interior of the silicon substrate is within the foregoing range, it can prevent such a phenomenon that the depth of the spacer regions recessed toward the interior of the silicon substrate is larger because the depth of the surfaces of the second regions that are recessed toward the interior of the silicon substrate is relatively large, thereby ensuring that a motion distance of a part of carriers is relatively short when the part bypasses the spacer regions and is transmitted to the first doped semiconductor layer or the second doped semiconductor layer. Meanwhile, a requirement for a relatively thick silicon substrate due to the relatively large depths of both the second regions and the spacer regions that are recessed toward the interior of the silicon substrate can be prevented. Thus, it can implement thinning production of the back contact solar cell while reducing the manufacturing costs of the back contact solar cell.

In a possible implementation, a depth of the bottom surfaces of the spacer regions that are recessed toward the interior of the silicon substrate relative to the surfaces of the first regions is greater than or equal to 2.5 µm and less than or equal to 9 µm.

By the adoption of the foregoing technical solution, when the depth of the bottom surfaces of the spacer regions that are recessed toward the interior of the silicon substrate relative to the surfaces of the first regions is within the foregoing range, it can prevent such a phenomenon that a depth of etching performed by using the etching agent on the spacer regions of the silicon substrate can be relatively small by strictly controlling etching duration after the portions of the second doped semiconductor layer located in the spacer regions are completely removed in an actual manufacturing process, to lower the etching difficulty. It can also prevent such a phenomenon, due to a relatively large depth, that a motion distance of carriers having corresponding conductivity types is relatively long when the carries bypass the spacer regions and are transmitted to the first doped semiconductor layer or the second doped semiconductor layer, to ensure that the carrier collection efficiency can be enhanced.

In a possible implementation, the back contact solar cell further includes a first passivation layer located between the silicon substrate and the first doped semiconductor layer.

By the adoption of the foregoing technical solution, the first passivation layer and the first doped semiconductor layer can constitute selective contact structures, to implement chemical passivation on the first regions of the back surface of the silicon substrate and implement selective collection on the carriers having the corresponding conductivity types, thereby reducing the carrier recombination rate on the back surface and helping enhance the photoelectric conversion efficiency of the back contact solar cell.

In a possible implementation, the back contact solar cell further includes a second passivation layer located between the silicon substrate and the second doped semiconductor layer.

By the adoption of the foregoing technical solution, the second passivation layer and the second doped semiconductor layer can constitute selective contact structures, to implement chemical passivation on the second regions of the back surface of the silicon substrate and implement selective collection on the carriers having the corresponding conductivity type, thereby reducing the carrier recombination rate on the back surface and helping enhance the photoelectric conversion efficiency of the back contact solar cell.

In a possible implementation, the surfaces of the first regions and/or the second regions are flat surfaces.

By the adoption of the foregoing technical solution, when the surfaces of the first regions are the flat surfaces, the surfaces of the first regions are relatively flat. It helps enhance the quality of the first doped semiconductor layer formed on the surfaces of the first regions, thereby enhancing the capability of the first doped semiconductor layer for transmitting the carriers having the corresponding conductivity types and helping enhance the operation performance of the back contact solar cell. In addition, for a beneficial effect when the surfaces of the second regions are the flat surfaces, refer to the beneficial effect when the surfaces of the first regions are the flat surfaces, and details are not described herein again.

In a possible implementation, the back contact solar cell further includes alignment marks located on the first doped semiconductor layer and/or the second doped semiconductor layer.

By the adoption of the foregoing technical solution, since the first side surfaces are located between the bottom surfaces of the spacer regions and the first doped semiconductor layer, and the second side surfaces are located between the bottom surfaces of the spacer regions and the second doped semiconductor layer, as boundary regions of different structures, the textured structures formed on the entire first side surfaces and the entire second side surfaces can cause a region with the first side surfaces and the second side surfaces to have lower brightness. It helps increase the contrast of a captured image, thereby more precisely identifying the alignment marks and enhancing the yield of battery production.

According to a second aspect, the present application further provides a manufacturing method for a back contact solar cell. The manufacturing method for the back contact solar cell includes the following steps: first, a silicon substrate is provided. A back surface of the silicon substrate has first regions and second regions that are alternately spaced apart from each other, and spacer regions located between the first regions and the second regions adjacent to the first regions. Next, a first doped semiconductor layer is formed in the first regions, and surfaces of the second regions and surfaces of the spacer regions are recessed toward an interior of the silicon substrate relative to surfaces of the first regions. Later, a second doped semiconductor layer is formed in the second regions. A conductivity type of the second doped semiconductor layer is opposite to a conductivity type of the first doped semiconductor layer. Then, the surfaces of the spacer regions are recessed toward the interior of the silicon substrate relative to the surfaces of the second regions, and texturing treatment is performed on bottom surfaces of the spacer regions, first side surfaces of the spacer regions close to the first regions, and second side surfaces of the spacer regions close to the second regions, to form the bottom surfaces, the first side surfaces, and the second side surfaces of the spacer regions as textured surfaces.

In a possible implementation, that texturing treatment is performed on bottom surfaces of the spacer regions, first side surfaces of the spacer regions close to the first regions, and second side surfaces of the spacer regions close to the second regions includes the following steps: First texturing treatment is performed on the bottom surfaces of the spacer regions, to form the bottom surfaces of the spacer regions as pre-formed textured structures. Then, second texturing treatment is performed on the bottom surfaces, the first side surfaces, and the second side surfaces of the spacer regions, to adjust a morphology of the pre-formed textured structures, and the first side surfaces and the second side surfaces are converted into the textured surfaces.

By the adoption of the foregoing technical solution, the first texturing treatment is first performed on the bottom surfaces of the spacer regions, to form the bottom surfaces of the spacer regions as the pre-formed textured structures. Meanwhile, the second texturing treatment is continued to be performed on the bottom surfaces, the first side surfaces, and the second side surfaces of the spacer regions, to ensure that the morphology of the pre-formed textured structures can be adjusted while the first side surfaces and the second side surfaces are converted into the textured surfaces, thereby ensuring that the surfaces of the spacer regions have relatively low reflectivity. This further increases the amount of light absorbed by the back surface of the back contact solar cell and enhances the photoelectric conversion efficiency of the back contact solar cell.

In a possible implementation, the pre-formed textured structures are pyramid-like structures; and/or, a height of the pre-formed textured structures is greater than or equal to 0.5 µm and less than or equal to 3 µm.

By the adoption of the foregoing technical solution, when the foregoing pre-formed textured structures are the pyramid-like structures, the textured structures on the bottom surfaces of the spacer regions can have a pyramid-like morphology after the second texturing treatment, thereby further enlarging a specific surface area of the bottom surfaces of the spacer regions and reducing the reflectivity of the bottom surfaces. In addition, if the height of the pre-formed textured structures is within the foregoing range, it can prevent such a phenomenon that the specific surface area of the bottom surfaces of the spacer regions is relatively small because the height of the pre-formed textured structures is relatively small, and it can ensure that the bottom surfaces of the spacer regions have relatively low reflectivity. In addition, it can also prevent such a phenomenon that portions of the spacer regions corresponding to the silicon substrate have a relatively large etching depth because the depth of the bottom surfaces of the spacer regions that need to be recessed toward the interior of the silicon substrate relative to the surfaces of the second regions is relatively large due to a relatively large height of the pre-formed textured structures, thereby helping implement thinning production. In addition, in a case that the pre-formed textured structures are the pyramid-like structures, the height of the pre-formed textured structures is within the foregoing range, so that it can also prevent a small number of pre-formed textured structures formed on the bottom surfaces of the spacer regions due to a relatively large overall size of the pre-formed textured structures because of the relatively large height of the pre-formed textured structures, thereby ensuring that the bottom surfaces of the spacer regions have a good light trapping effect after the second texturing treatment.

In a possible implementation, a wet chemical etching solution used in the second texturing treatment includes a texturing additive, and a volume ratio of the texturing additive in the wet chemical etching solution is greater than or equal to 0.01% and less than or equal to 5%; and/or, a treatment temperature of the second texturing treatment is greater than or equal to 50°C and less than or equal to 85°C; and/or, treatment duration of the second texturing treatment is greater than or equal to 30 s and less than or equal to 240 s.

By the adoption of the foregoing technical solution, the wet chemical etching solution includes the texturing additive, to ensure that after the second texturing treatment, the first side surfaces and the second side surfaces are converted into the textured surfaces, to reduce the reflectivity of the first side surfaces and the reflectivity of the second side surfaces. In addition, if the volume ratio of the texturing additive in the wet chemical etching solution is within the foregoing range, it can prevent a relatively small size of the textured structures and/or a relatively small number of textured structures on both the first side surfaces and the second side surfaces after the second texturing treatment due to a relatively small volume ratio, thereby ensuring that the first side surfaces and the second side surfaces have relatively high surface coarseness after the second texturing treatment. It can also prevent a relatively large amplitude of adjustment on the morphology of the textured structures, formed based on the pre-formed textured structures, on the bottom surfaces of the spacer regions after the second texturing treatment due to a relatively large volume ratio, thereby ensuring that the bottom surfaces of the spacer regions have a good light trapping effect. In addition, both the treatment temperature and the treatment duration of the second texturing treatment affect a size of the textured structures formed on the bottom surfaces, the first side surfaces, and the second side surfaces of the spacer regions through the second texturing treatment. Based on this, when the treatment temperature of the second texturing treatment is within the foregoing range, it can prevent a relatively small size of the textured structures due to a relatively small treatment temperature. In addition, it can also prevent a relatively large size of the textured structures due to a relatively large treatment temperature. For a beneficial effect of prevention of the relatively small and large sizes of the textured structures, refer to the above description. In addition, a beneficial effect of the treatment duration being within the foregoing range is similar to the beneficial effect of the treatment temperature being greater than or equal to 50°C and less than or equal to 85°C, and details are not described herein.

In a possible implementation, that first doped semiconductor layer are formed in the first regions, and surfaces of the second regions and surfaces of the spacer regions are recessed toward an interior of the silicon substrate relative to surfaces of the first regions includes the following steps: First doped semiconductor layer disposed as a whole layer and first mask layer located on portions of the first doped semiconductor layer corresponding to the first regions are formed on the back surface of the silicon substrate. Next, portions of the first doped semiconductor layer located in the spacer regions and the second regions are selectively removed under a masking action of the first mask layer. The surfaces of the spacer regions and the surfaces of the second regions are recessed toward the interior of the silicon substrate relative to the surfaces of the first regions.

In a possible implementation, the manufacturing method for the back contact solar cell includes: after the surfaces of the second regions and the surfaces of the spacer regions are recessed toward the interior of the silicon substrate relative to the surfaces of the first regions, the following steps are performed: The second doped semiconductor layer are deposited on the first doped semiconductor layer and in the spacer regions and the second regions. In addition, a second mask layer is formed on portions of the second doped semiconductor layer corresponding to the second regions. Next, portions of the second doped semiconductor layer corresponding to the first regions and the spacer regions are selectively removed under a masking action of the second mask layer. The surfaces of the spacer regions are recessed toward the interior of the silicon substrate relative to the surfaces of the second regions, and the texturing treatment is performed on the bottom surfaces of the spacer regions, the first side surfaces of the spacer regions close to the first regions, and the second side surfaces of the spacer regions close to the second regions.

In a possible implementation, a material of the first doped semiconductor layer includes silicon. That first doped semiconductor layer disposed as a whole layer and first mask layer located on portions of the first doped semiconductor layer corresponding to the first regions are formed on the back surface of the silicon substrate includes the following steps: First intrinsic semiconductor layers disposed as a whole layer are formed on the back surface of the silicon substrate. Next, doping treatment is performed on the first intrinsic semiconductor layers, to convert the first intrinsic semiconductor layers into the first doped semiconductor layer and form, on the first doped semiconductor layer, a first doped silica glass layer disposed as a whole layer. Later, heat treatment is performed on portions of the first doped silica glass layer corresponding to the spacer regions and the second regions, to form portions of the first doped silica glass layer that are not subjected to the heat treatment as the first mask layer. Then, a portion of the first doped silica glass layer that is subjected to the heat treatment is removed.

By the adoption of the foregoing technical solution, when the material of the first doped semiconductor layer includes the silicon, a material for manufacturing the first intrinsic semiconductor layers of the first doped semiconductor layer also includes silicon. Based on this, after the doping treatment is performed on the first intrinsic semiconductor layers, the first doped semiconductor layer can be obtained, and the first doped silica glass layer disposed as a whole layer can be further formed on the first doped semiconductor layer. Then, the heat treatment is performed on a portion of the first doped silica glass layer by using a laser etching process. In this case, the compactness of the portion of the first doped silica glass layer that is subjected to laser treatment is reduced, so that the portion is easily removed. The compactness of portion of the first doped silica glass layer that is not subjected to laser treatment is relatively high, so that the portion is hardly removed. Thus, after the heat treatment, different portions of the first doped silica glass layer have different etching selectivity ratios, and the first mask layer for performing patterning treatment on the first doped semiconductor layer are obtained, instead of additionally forming other mask materials and forming other mask deposition procedures to obtain the first mask layer. It helps reduce the manufacturing costs of the back contact solar cell and simplify the manufacturing flow of the back contact solar cell.

In a possible implementation, the portions of the first doped semiconductor layer located in the spacer regions and the second regions are selectively removed under the masking action of the first mask layer by using a wet chemical process. The surfaces of the spacer regions and the surfaces of the second regions are recessed toward the interior of the silicon substrate relative to the surfaces of the first regions. A process temperature of the wet chemical process is greater than or equal to 60°C and less than or equal to 85°C; and/or, process duration of the wet chemical process is greater than or equal to 40 s and less than or equal to 300 s; and/or, a wet chemical etching solution used in the wet chemical process is an alkaline wet chemical etching solution, and a volume ratio of an alkaline component in the alkaline wet chemical etching solution is greater than or equal to 2% and less than or equal to 20%; and/or, the wet chemical etching solution used in the wet chemical process includes a polishing additive, and a volume ratio of the polishing additive in the wet chemical etching solution is greater than or equal to 0.5% and less than or equal to 5%.

By the adoption of the foregoing technical solution, the process temperature and the process duration of the wet chemical process can affect the depth of the surfaces of both the second regions and the spacer regions that are recessed toward the interior of the silicon substrate relative to the surfaces of the first regions through the wet chemical process. Based on this, when the process temperature of the wet chemical process is within the foregoing range, it can prevent such a phenomenon that the depth of the surfaces of both the second regions and the spacer regions that are recessed toward the interior of the silicon substrate relative to the surfaces of the first regions because of a relatively small process temperature. In addition, it can also prevent such a phenomenon that the depth of the surfaces of both the second regions and the spacer regions that are recessed toward the interior of the silicon substrate relative to the surfaces of the first regions is relatively large because of a relatively large process temperature. For a beneficial effect of prevention of the relatively small and large depths of the surfaces of both the second regions and the spacer regions that are recessed toward the interior of the silicon substrate relative to the surfaces of the first regions, refer to the above description. In addition, a beneficial effect of the process duration and the volume ratio of the alkali component being within the foregoing ranges is similar to the beneficial effect of the process temperature being greater than or equal to 60°C and less than or equal to 85°C, and details are not described herein. In addition, when the volume ratio of the polishing additive in the wet chemical etching solution is within the foregoing range, the flatness of the surfaces of the second regions and the spacer regions that are subjected to selective removal can be enhanced. This helps enhance the forming quality of the second doped semiconductor layer and the forming quality of the textured structures formed on the surfaces of the spacer regions, and ensures that the textured structures formed on the surfaces of the spacer regions are uniformly distributed, so that the portions of the spacer regions have a good light trapping effect.

In a possible implementation, a material of the second doped semiconductor layer includes silicon. Furthermore, the second doped semiconductor layer are deposited on the first doped semiconductor layer and in the spacer regions and the second regions. That a second mask layer is formed on portions of the second doped semiconductor layer corresponding to the second regions includes the following steps: Second intrinsic semiconductor layers are formed on the first doped semiconductor layer and in the spacer regions and the second regions. Next, doping treatment is performed on the second intrinsic semiconductor layers, to convert the second intrinsic semiconductor layers into the second doped semiconductor layer and form, on the second doped semiconductor layer, a a second doped silica glass layer disposed as a whole layer. Later, heat treatment is performed on portions of the second doped silica glass layer corresponding to the first regions and the spacer regions, to convert portions of the second doped silica glass layer corresponding to the second regions into the second mask layer. Then, a portion of the second doped silica glass layer that is subjected to the heat treatment is removed.

By the adoption of the foregoing technical solution, when the material of the second doped semiconductor layer includes the silicon, a material for manufacturing the second intrinsic semiconductor layers of the first doped semiconductor layer also includes silicon. Based on this, after the doping treatment is performed on the second intrinsic semiconductor layers, the second doped semiconductor layer can be obtained, and the second doped silica glass layer disposed as a whole layer can be further formed on the second doped semiconductor layer. Then, the heat treatment is performed on the portions of the second doped silica glass layer corresponding to the first regions and the spacer regions by using a laser etching process. In this case, the compactness of a portion of the second doped silica glass layer that is subjected to laser treatment is reduced, so that the portion is easily removed. The portions of the second doped silica glass layer corresponding to the second regions are not subjected to laser treatment. In this case, the compactness of the portions of the second doped silica glass layer corresponding to the second regions is relatively high, so that the portions are hardly removed. Thus, after the heat treatment, different portions of the second doped silica glass layer have different etching selectivity ratios, and the second mask layer for performing patterning treatment on the second doped semiconductor layer are obtained, instead of additionally forming other mask materials and forming other mask deposition procedures to obtain the second mask layer. It helps reduce the manufacturing costs of the back contact solar cell and simplify the manufacturing flow of the back contact solar cell.

In a possible implementation, the manufacturing method for the back contact solar cell further includes: A first passivation layer is formed in the first regions before the first doped semiconductor layer is formed in the first regions; and/or, the manufacturing method for the back contact solar cell further includes: A second passivation layer is formed in the second regions before the second doped semiconductor layer is formed in the portions of the second regions.

In a possible implementation, the manufacturing method for the back contact solar cell further includes: Alignment marks are formed on the first doped semiconductor layer and/or the second doped semiconductor layer.

For beneficial effects of the second aspect and various implementations of the second aspect in the present application, refer to the analysis of the beneficial effects of the first aspect and various implementations of the first aspect, and details are not described herein.

### BRIEF DESCRIPTION OF THE DRAWINGS

The accompanying drawings described here are used to provide a further understanding of the present application and form a part of the present application. The illustrative embodiments and their explanations of the present application are used to explain the present application and do not constitute an improper limitation on the present application. In the accompanying drawings:
FIG. 1 is a scanning electron microscope (SEM) image of a structure of a spacer region located between a first doped semiconductor layer and a second doped semiconductor layer in the related art;
FIG. 2 is a SEM image of a structure of a portion of a spacer region in the related art;
FIG. 3 is a first schematic longitudinal cross-sectional view of a structure of a back contact solar cell according to an embodiment of the present application;
FIG. 4 is a schematic enlarged longitudinal cross-sectional view of a part of a structure in a spacer region according to an embodiment of the present application;
FIG. 5 is a first SEM image of a first side surface and a part of a spacer region in an embodiment of the present application;
FIG. 6 is a second SEM image of a first side surface and a part of a spacer region in an embodiment of the present application;
FIG. 7 is a third SEM image of a first side surface and a part of a spacer region in an embodiment of the present application;
FIG. 8 is a fourth SEM image of a first side surface and a part of a spacer region in an embodiment of the present application;
FIG. 9 is an SEM image of a first side surface or a second side surface in an embodiment of the present application;
FIG. 10 is a fifth SEM image of a first side surface and a part of a spacer region in an embodiment of the present application;
FIG. 11 is a sixth SEM image of a first side surface and a part of a spacer region in an embodiment of the present application;
FIG. 12 is a seventh SEM image of a first side surface and a part of a spacer region in an embodiment of the present application;
FIG. 13 is a second schematic longitudinal cross-sectional view of a structure of a back contact solar cell according to an embodiment of the present application;
FIG. 14 is a first schematic longitudinal cross-sectional view of a structure of a back contact solar cell in a manufacturing process according to an embodiment of the present application;
FIG. 15 is a second schematic longitudinal cross-sectional view of a structure of a back contact solar cell in a manufacturing process according to an embodiment of the present application;
FIG. 16 is a third schematic longitudinal cross-sectional view of a structure of a back contact solar cell in a manufacturing process according to an embodiment of the present application;
FIG. 17 is a fourth schematic longitudinal cross-sectional view of a structure of a back contact solar cell in a manufacturing process according to an embodiment of the present application;
FIG. 18 is a fifth schematic longitudinal cross-sectional view of a structure of a back contact solar cell in a manufacturing process according to an embodiment of the present application;
FIG. 19 is a sixth schematic longitudinal cross-sectional view of a structure of a back contact solar cell in a manufacturing process according to an embodiment of the present application;
FIG. 20 is a seventh schematic longitudinal cross-sectional view of a structure of a back contact solar cell in a manufacturing process according to an embodiment of the present application;
FIG. 21 is an eighth schematic longitudinal cross-sectional view of a structure of a back contact solar cell in a manufacturing process according to an embodiment of the present application;
FIG. 22 is a ninth schematic longitudinal cross-sectional view of a structure of a back contact solar cell in a manufacturing process according to an embodiment of the present application;
FIG. 23 is a tenth schematic longitudinal cross-sectional view of a structure of a back contact solar cell in a manufacturing process according to an embodiment of the present application;
FIG. 24 is an eleventh schematic longitudinal cross-sectional view of a structure of a back contact solar cell in a manufacturing process according to an embodiment of the present application;
FIG. 25 is a twelfth schematic longitudinal cross-sectional view of a structure of a back contact solar cell in a manufacturing process according to an embodiment of the present application;
FIG. 26 is a thirteenth schematic longitudinal cross-sectional view of a structure of a back contact solar cell in a manufacturing process according to an embodiment of the present application; and
FIG. 27 is a fourteenth schematic longitudinal cross-sectional view of a structure of a back contact solar cell in a manufacturing process according to an embodiment of the present application.

Reference numerals in the accompanying drawings: 11: silicon substrate; 12: first doped semiconductor layer; 13: second doped semiconductor layer; 14: first region; 15: second region; 16: spacer region; 17: first passivation layer; 18: second passivation layer; 19: first mask layer; 20: second mask layer; 21: first intrinsic semiconductor layer; 22: first doped silica glass layer; 23: second intrinsic semiconductor layer; and 24: second doped silica glass layer.

### DETAILED DESCRIPTION

The embodiments of the present application will be described below with reference to the accompanying drawings. However, it should be understood that these descriptions are only illustrative and not intended to limit the scope of the present application. In addition, in the following explanation, descriptions of well-known structures and techniques have been omitted to avoid unnecessary confusion with the concepts of the present application.

Various schematic diagrams of structures according to the embodiments of the present application are shown in the accompanying drawings. These drawings are not drawn to scale. For the purpose of clarity, some details have been enlarged, and some details may possibly have been omitted. Shapes of various regions and layers shown in the drawings, as well as their relative sizes and positional relationships, are only exemplary. In practice, there may be deviations due to manufacturing tolerances or technical limitations. In addition, a person skilled in the art can additionally design regions/layers with different shapes, sizes, and relative positions according to actual needs.

In the context of the present application, when a layer/component is referred to as being located "above" another layer/component, the layer/component can be directly located on the another layer/component, or there can be an intermediate layer/component between them. In addition, if a layer/component is located "above" another layer/component in an orientation, when the orientation is reversed, the layer/component can be located "below" the another layer/component. In order to make the technical problems, technical solutions, and beneficial effects to be solved by the present application clearer, the following is a further detailed explanation of the present application in conjunction with the accompanying drawings and embodiments. It should be understood that the specific embodiments described here are only intended to explain the present application and are not intended to limit the present application.

In addition, the terms "first" and "second" are used for descriptive purposes only and are not to be construed as indicating or implying relative importance or to implicitly indicate the number of technical features indicated. From this, features defined as "first" and "second" may explicitly or implicitly include one or more features. In the description of the present application, "a plurality of" means two or more, unless otherwise expressly and specifically defined. Unless otherwise explicitly and specifically limited, "several" means one or more than one.

In addition, in the description of the present application, it should be noted that, unless otherwise explicitly specified or defined, the terms such as "mount", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, an internal communication of two elements, or interaction between two elements, unless expressly specified otherwise. A person of ordinary skill in the art may understand the specific meanings of the foregoing terms in this application according to specific situations.

Currently, solar cells are increasingly widely used as a new energy alternative solution. A photovoltaic solar cell is an apparatus for converting light energy of the sun into electrical energy. Specifically, the solar cell generates carriers by using the photovoltaic principle, and leads the carriers out by using electrodes, thereby facilitating the effective use of the electric energy. When a positive electrode and a negative electrode included in the solar cell are both located on a back surface of the solar cell, the solar cell is referred to as a back contact solar cell. A front surface of the back contact solar cell is not blocked by any metal electrode, so that the back contact solar cell has a higher short-circuit current I_{sc} and is one of existing technical directions for implement efficient crystalline silicon solar cells.

Specifically, the existing back contact solar cell at least includes a silicon substrate, and a first doped semiconductor layer formed in part of a region on a back surface of the silicon substrate. A conductivity type of the first doped semiconductor layer is opposite to a conductivity type of the silicon substrate. Alternatively, the conductivity type of the first doped semiconductor layer is the same as the conductivity type of the silicon substrate. In this case, the back contact solar cell further includes a second doped semiconductor layer formed in part of the region on the back surface of the silicon substrate, and a conductivity type of the second doped semiconductor layer is opposite to the conductivity type of the first doped semiconductor layer. In addition, regardless of a specific structure of the back contact solar cell, two doped regions with opposite conductivity types are arranged on the back surface of the back contact solar cell, and the two doped regions with opposite conductivity types are spaced apart from each other to prevent a short circuit.

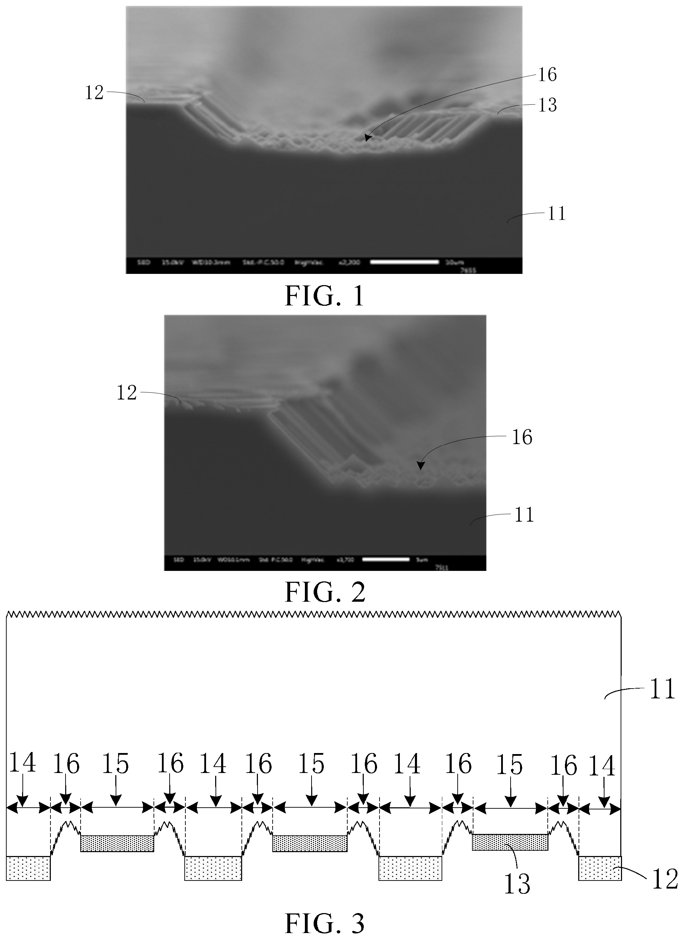

In an actual process of manufacturing the foregoing back contact solar cell, a doped semiconductor material layer disposed as a whole layer needs to be first formed on the back surface of the silicon substrate, and a doped semiconductor material layer located in part of the region of the back surface is selectively removed to obtain the first doped semiconductor layer. Correspondingly, the foregoing manner is also used to form the second doped semiconductor layer in part of the region of the back surface. As shown in FIG. 1 and FIG. 2, to prevent a short circuit caused by electrical connection between the first doped semiconductor layer 12 and the second doped semiconductor layer 13, in the existing manufacturing method, a spacer region 16 having a width is formed between the first doped semiconductor layer 12 and the second doped semiconductor layer 13 through wet chemical etching or the like, and a surface of the spacer region 16 is recessed toward an interior of the silicon substrate relative to a surface of the silicon substrate 11.

However, as shown in FIG. 1 and FIG. 2, in the existing back contact solar cell, only a bottom surface of the spacer region 16 disposed between the first doped semiconductor layer 12 and the second doped semiconductor layer 13 is a textured surface, and a side surface of the spacer region 16 close to the first doped semiconductor layer 12 and a side surface of the spacer region 16 close to the second doped semiconductor layer 13 are relatively flat surfaces. Consequently, the two side surfaces have relatively high reflectivity to light due to low coarseness. As a result, the light utilization of the back contact solar cell is reduced, and it does not help enhance the photoelectric conversion efficiency of the back contact solar cell.

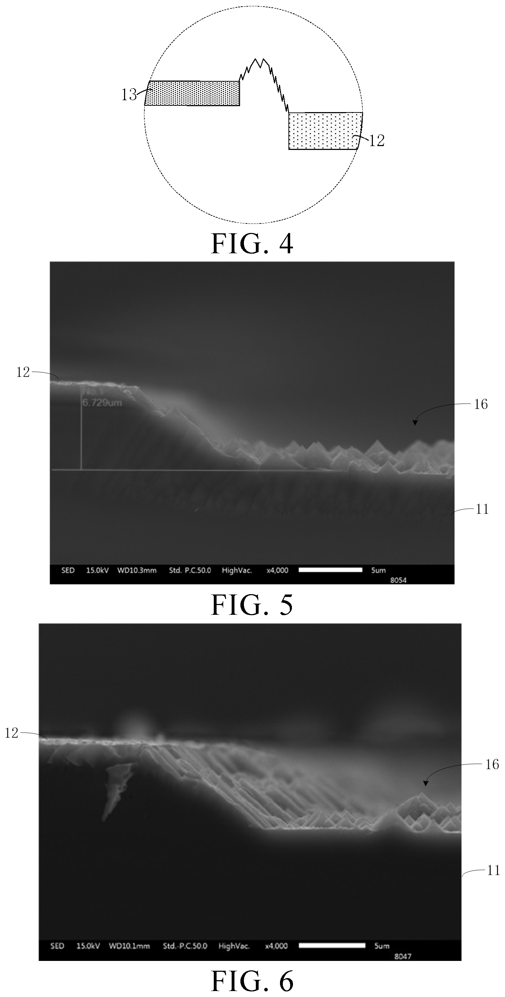

To solve the foregoing technical problems, according to a first aspect, an embodiment of the present application provides a back contact solar cell. As shown in FIG. 3 and FIG. 4, the back contact solar cell includes: a silicon substrate 11, and first doped semiconductor layer 12 and second doped semiconductor layer 13 that are alternately distributed in a spaced manner on a back surface of the silicon substrate 11. A conductivity type of the first doped semiconductor layer 12 is opposite to a conductivity type of the second doped semiconductor layer 13. On the back surface of the silicon substrate 11, regions corresponding to the first doped semiconductor layer 12 are first regions 14; regions corresponding to the second doped semiconductor layer 13 are second regions 15; and regions between the first regions 14 and second regions 15 adjacent to the first regions 14 are spacer regions 16. Surfaces of the second regions 15 are recessed toward an interior of the silicon substrate 11 relative to surfaces of the first regions 14. Surfaces of the spacer regions 16 are recessed toward the interior of the silicon substrate 11 relative to the surfaces of the second regions 15. Bottom surfaces of the spacer regions 16, first side surfaces of the spacer regions 16 close to the first regions 14, and second side surfaces of the spacer regions 16 close to the second regions 15 are textured surfaces.

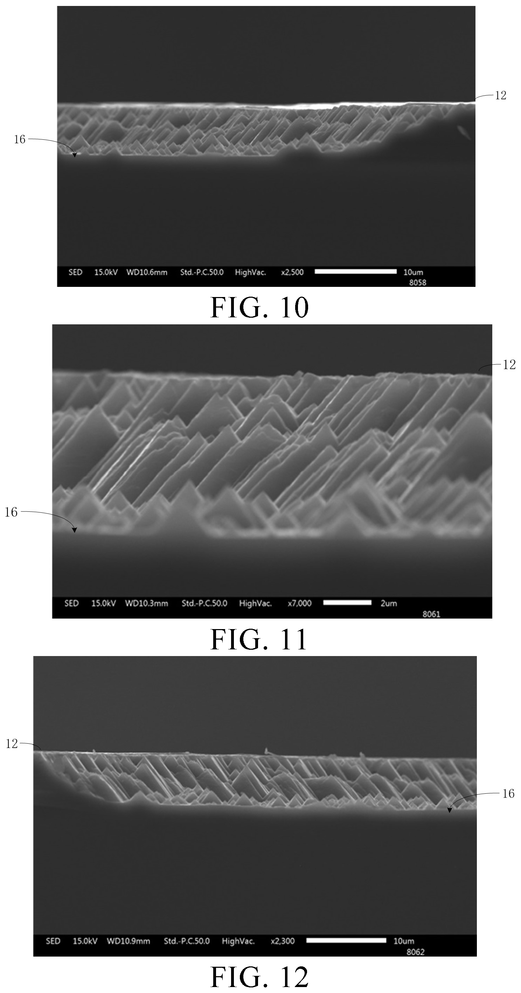

It should be noted that as shown in FIG. 3 to FIG. 12, in a case that the bottom surfaces, the first side surfaces, and the second side surfaces of the spacer regions 16 are the textured surfaces, textured structures are formed in regions of the bottom surfaces, the first side surfaces, and the second side surfaces of the spacer regions 16. That is, the regions of the bottom surfaces, the first side surfaces, and the second side surfaces of the spacer regions 16 have a relatively large specific surface area and a relatively good light trapping effect.

By the adoption of the foregoing technical solution, as shown in FIG. 3, in the back contact solar cell provided in the embodiment of the present application, the first doped semiconductor layer 12 and the second doped semiconductor layer 13 that have opposite conductivity types are alternately distributed in the spaced manner on the back surface of the silicon substrate 11. Based on this, the spacer regions 16 on the back surface of the silicon substrate 11 can separate the first doped semiconductor layer 12 formed in the first regions 14 from the second doped semiconductor layer 13 formed in the second regions 15, to reduce the carrier recombination rate at lateral interfaces of the first doped semiconductor layer 12 and the second doped semiconductor layer 13. This helps enhance the photoelectric conversion efficiency of the back contact solar cell. In addition, the surfaces of the second regions 15 are recessed toward the interior of the silicon substrate 11 relative to the surfaces of the first regions 14, and the surfaces of the spacer regions 16 are recessed toward the interior of the silicon substrate 11 relative to the surfaces of the second regions 15. It indicates that in an actual manufacturing process, after the first doped semiconductor layer 12 covering the entire back surface as a whole layer is formed, the portions of the first doped semiconductor layer 12 located in the second regions 15 and the spacer regions 16 are completely removed. Moreover, after selective etching on the first doped semiconductor layer 12 is implemented, and the second doped semiconductor layer 13 are deposited as a whole layer, the portions of the second doped semiconductor layer 13 located on the first doped semiconductor layer 12 and in the spacer regions 16 are completely removed, to prevent leakage caused by residuals still existing on surfaces of corresponding regions after the first doped semiconductor layer 12 and/or the second doped semiconductor layer 13 are selectively etched. Meanwhile, when the surfaces of the second regions 15 are recessed toward the interior of the silicon substrate 11 relative to the surfaces of the first regions 14, it also helps at least partially stagger, in a thickness direction of the silicon substrate 11, the first doped semiconductor layer 12 and the second doped semiconductor layer 13 that are jointly located on the back surface of the silicon substrate 11 and have the opposite conductivity types, thereby further lowering a risk of electric leakage of the back surface and enhancing the electrical reliability of the back contact solar cell. In addition, as shown in FIG. 3 and FIG. 4, in the back contact solar cell provided in the embodiment of the present application, the bottom surfaces of the spacer regions 16 are the textured surfaces, and the first side surfaces of the spacer regions 16 close to the first regions 14 and the second side surfaces of the spacer regions 16 close to the second regions 15 are also textured surfaces. Compared with a flat surface, the textured surface has a relatively good light trapping effect with its concave-convex surface feature, and can reduce the reflectivity of the bottom surfaces, the first side surfaces, and the second side surfaces of the spacer regions 16. In this case, compared with the existing back contact solar cell in which the first side surfaces and the second side surfaces are flat surfaces, the back contact solar cell provided in the embodiment of the present application helps refract more light from the first side surfaces and the second side surfaces into the silicon substrate 11 and cause the silicon substrate 11 to use the light, thereby helping enhance the photoelectric conversion efficiency of the back contact solar cell.

Specifically, the back contact solar cell further includes alignment marks located on the first doped semiconductor layer 12 and/or the second doped semiconductor layer 13.

Since the first side surfaces are located between the bottom surfaces of the spacer regions and the first doped semiconductor layer, and the second side surfaces are located between the bottom surfaces of the spacer regions and the second doped semiconductor layer, as boundary regions of different structures, the textured structures formed on the entire first side surfaces and the entire second side surfaces can cause a region with the first side surfaces and the second side surfaces to have lower brightness. It helps increase the contrast of a captured image, thereby more precisely identifying the alignment marks and enhancing the yield of battery production.

In an actual application process, a light receiving surface of the silicon substrate is a flat surface. Alternatively, as shown in FIG. 3, the light receiving surface of the silicon substrate 11 is a textured surface. Since a textured surface has a light trapping effect, when the light receiving surface of the silicon substrate 11 is a textured surface, the reflectivity of the light receiving surface can be reduced. This helps refract more light from the light receiving surface into the silicon substrate 11 and cause the silicon substrate 11 to use the light, thereby enhancing the photoelectric conversion efficiency of the back contact solar cell.

In addition, from a range perspective, boundaries of the first regions 14, the second regions 15, and the spacer regions 16 of the back surface of the silicon substrate are virtual boundaries. As shown in FIG. 3, the first doped semiconductor layer 12 are formed in the first regions 14. Thus, a range of the first regions 14 on the back surface of the silicon substrate 11 can be determined based on a requirement for a forming range of the first doped semiconductor layer 12 in an actual application scenario. Further, the second doped semiconductor layer 13 are formed in the second regions 15. Thus, a range of the second regions 15 on the back surface of the silicon substrate 11 can be determined according to a requirement for a forming range of the second doped semiconductor layer 13 in an actual application scenario. Regarding the spacer regions 16, as described above, the spacer regions 16 can separate the first doped semiconductor layer 12 and the second doped semiconductor layer 13 that have the opposite conductivity types, so as to suppress electric leakage. Thus, a range of the spacer regions 16 on the back surface can be determined according to a requirement for an anti-leakage distance between the first doped semiconductor layer 12 and the second doped semiconductor layer 13 in an actual application scenario.

For example, in an arrangement direction of the first regions and the second regions, a length of the spacer regions is greater than or equal to 20 µm and less than or equal to 110 µm. For example, the length of the spacer regions is 20 µm, 40 µm, 60 µm, 80 µm, 100 µm, 110 µm, etc. In this case, when the length of the spacer regions is within the foregoing range, it can prevent electric leakage between the first doped semiconductor layer 12 and the second doped semiconductor layer 13 due to a relatively small distance, and ensure that the back contact solar cell has relatively high electrical reliability. In addition, it can also prevent a phenomenon that carriers on the back surface fail to be collected by the first doped semiconductor layer 12 and/or the second doped semiconductor layer 13 and are exported by corresponding electrodes in a timely manner due to relatively small forming ranges of both the first doped semiconductor layer 12 and/or the second doped semiconductor layer 13 on the back surface because of a relatively long distance, to reduce the carrier recombination rate on the back surface.

From a perspective of depth of recessing, a depth of the second regions 15 recessed toward the interior of the silicon substrate on the back surface of the silicon substrate 11 and a depth of the spacer regions 16 recessed toward the interior of the silicon substrate on the back surface of the silicon substrate 11 can be determined based on an actual application scenario, as long as it is ensured that the surfaces of the second regions 15 are recessed toward the interior of the silicon substrate relative to the surfaces of the first regions 14 and the surfaces of the spacer regions 16 are recessed toward the interior of the silicon substrate 11 relative to the surfaces of the second regions 15.

For example, the depth of the surfaces of the second regions 15 that are recessed toward the interior of the silicon substrate 11 relative to the surfaces of the first regions 14 are greater than or equal to 0.5 µm and less than or equal to 3 µm. For example, the depth of the surfaces of the second regions 15 that are recessed toward the interior of the silicon substrate 11 relative to the surfaces of the first regions 14 is 0.5 µm, 1 µm, 1.5 µm, 2 µm, 2.5 µm, 3 µm, or the like. In this case, when the depth of the surfaces of the second regions 15 that are recessed toward the interior of the silicon substrate 11 is within the foregoing range, it can prevent a small degree of staggering, in the thickness direction of the silicon substrate due to a relatively small depth of the surfaces of the second regions 15 that are recessed toward the interior of the silicon substrate 11, between the first doped semiconductor layer 12 and the second doped semiconductor layer 13 that are jointly located on the back surface of the silicon substrate and have the opposite conductivity types, to further lower the risk of electric leakage of the back surface. In addition, the spacer regions 16 are recessed toward the silicon substrate 11 relative to the second regions 15. That is, compared with the second regions 15, the depth of the spacer regions 16 recessed toward the interior of the silicon substrate 11 is larger. Therefore, when the depth of the surfaces of the second regions 15 that are recessed toward the interior of the silicon substrate 11 is within the foregoing range, it can prevent such a phenomenon that the depth of the spacer regions 16 recessed toward the interior of the silicon substrate 11 is larger because the depth of the surfaces of the second regions 15 that are recessed toward the interior of the silicon substrate 11 is relatively large, thereby ensuring that a motion distance of a part of carriers is relatively short when the part bypasses the spacer regions 16 and is transmitted to the first doped semiconductor layer 12 or the second doped semiconductor layer 13. Meanwhile, a requirement for a relatively thick silicon substrate 11 due to the relatively large depths of both the second regions 15 and the spacer regions 16 that are recessed toward the interior of the silicon substrate 11 can be prevented. Thus, it can implement thinning production of the back contact solar cell while reducing the manufacturing costs of the back contact solar cell.

For example, the depth of the surfaces of the spacer regions 16 that are recessed toward the interior of the silicon substrate 11 relative to the surfaces of the first regions 14 are greater than or equal to 2.5 µm and less than or equal to 9 µm. For example, the depth of the surfaces of the spacer regions 16 that are recessed toward the interior of the silicon substrate 11 relative to the surfaces of the first regions 14 is 2.5 µm, 3 µm, 4 µm, 5 µm, 6 µm, 7 µm, 8 µm, 9 µm, or the like. In this case, when the depth of the bottom surfaces of the spacer regions 16 that are recessed toward the interior of the silicon substrate 11 relative to the surfaces of the first regions 14 is within the foregoing range, it can prevent such a phenomenon that a depth of etching performed by using an etching agent on the spacer regions 16 of the silicon substrate 11 can be relatively small by strictly controlling etching duration after the portions of the second doped semiconductor layer 13 located in the spacer regions 16 are completely removed in an actual manufacturing process, to lower the etching difficulty. It can also prevent such a phenomenon, due to a relatively large depth, that a motion distance of carriers having corresponding conductivity types is relatively long when the carries bypass the spacer regions 16 and are transmitted to the first doped semiconductor layer 12 or the second doped semiconductor layer 13, to ensure that the carrier collection efficiency can be enhanced.

It should be noted that since the bottom surfaces of the spacer regions 16 are the textured surfaces, the depth of the bottom surfaces of the spacer regions 16 that are recessed toward the interior of the silicon substrate 11 relative to the surfaces of the first regions 14 is equal to a vertical distance from middle portions of the textured structures formed on the bottom surfaces of the spacer regions 16 to the surfaces of the first regions 14.

In terms of surface morphology, in the back surface of the silicon substrate 11, surfaces of the first regions 14 and surface of the second regions 15 are textured surfaces. Alternatively, as shown in FIG. 3, the surfaces of the first regions 14 and the surfaces of the second regions 15 are alternatively flat surfaces. When the surfaces of the first regions 14 are the flat surfaces, the surfaces of the first regions 14 are relatively flat. It helps enhance the quality of the first doped semiconductor layer 12 formed on the surfaces of the first regions 14, thereby enhancing the capability of the first doped semiconductor layer 12 for transmitting the carriers having the corresponding conductivity types and helping enhance the operation performance of the back contact solar cell. In addition, for a beneficial effect when the surfaces of the second regions 15 are the flat surfaces, refer to the beneficial effect when the surfaces of the first regions 14 are the flat surfaces, and details are not described herein again.

Regarding the spacer regions 16, the bottom surfaces of the spacer regions 16 are the textured surfaces, and a specific morphology of the textured structures formed on the bottom surfaces can be determined based on an actual requirement and an actual manufacturing process. For example, the textured structures formed on the bottom surfaces of the spacer regions 16 are pyramid-like structures, quasi-V-shaped groove structures, inverted pyramid-like structures, or the like.

For example, as shown in FIG. 4 to FIG. 12, the textured structures on the bottom surfaces of the spacer regions 16 are pyramid-like structures whose surfaces have recesses. In this case, the pyramid-like structure is a pentahedron-like structure. Compared with a textured structure having a relatively small quantity of surfaces, such as a V-shaped groove, when the textured structures on the bottom surfaces of the spacer regions 16 are the pyramid-like structure, it helps enlarge a specific surface area of the bottom surfaces of the spacer regions 16. In addition, surfaces of the textured structures on the bottom surfaces of the spacer regions 16 have recesses, that is, the surfaces of the textured structures are uneven. This can further increase the coarseness of the bottom surfaces of the spacer regions 16, thereby helping reduce the reflectivity of the spacer regions 16.

With regard to a morphology of the first side surfaces of the spacer regions 16 close to the first regions 14 and a morphology of the second side surfaces of the spacer regions 16 close to the second regions 15, the first side surfaces and the second side surfaces can be vertically disposed relative to a horizontal plane. Alternatively, as shown in FIG. 3 and FIG. 4, the first side surfaces and the second side surfaces are obliquely disposed relative to the horizontal plane, so that a cross-sectional area of the spacer regions 16 gradually increases in a direction from a light receiving surface to the back surface. The horizontal plane in the present application refers to a horizontal plane at which the silicon substrate of the back contact solar cell is located. In this case, when the cross-sectional area of one side of the spacer regions 16 close to the light receiving surface is smaller than the cross-sectional area of one side of the spacer regions close to the back surface, it helps increase a distance between the first doped semiconductor layer 12 and the second doped semiconductor layer 13 having the conductivity type opposite to the conductivity type of the first doped semiconductor layer, to lower a risk of electric leakage on the back surface of the back contact solar cell and ensure that the back contact solar cell has relatively high electrical reliability. In addition, compared with the first side surfaces and the second side surfaces being both vertically disposed relative to the horizontal plane, that the first side surfaces and the second side surfaces are respectively obliquely disposed relative to the horizontal plane can also increase an area ratio of orthographic projections of both the first side surfaces and the second side surfaces on the back surface. This can further reduce the reflectivity of the back surface, so that more light can enter the silicon substrate 11 from the back surface of the back contact solar cell under the light trapping effect of both the first side surfaces and the second side surfaces, thereby helping enhance the photoelectric conversion efficiency of the back contact solar cell.

In the foregoing case, angles respectively between the first side surfaces and the horizontal plane and between the second side surfaces and the horizontal plane can be determined based on a requirement for the reflectivity of the back surface in an actual manufacturing process and the depth of the spacer regions 16 recessed toward the interior of the silicon substrate 11 relative to the surfaces of the second region 15. This is not specifically limited herein.

For example, as shown in FIG. 3 and FIG. 4, the angles respectively between the first side surfaces and the horizontal plane and between the second side surfaces and the horizontal plane are greater than or equal to 52° and less than or equal to 58°. For example, the angles respectively between the first side surfaces and the horizontal plane and between the second side surfaces and the horizontal plane are 52°, 53°, 54°, 55°, 56°, 57°, 58°, or the like. In this case, when the angles respectively between the first side surfaces and the horizontal plane and between the second side surfaces and the horizontal plane are within the foregoing ranges, it can prevent such a phenomenon that the effect of reducing the reflectivity of the back surface by using the first side surfaces and the second side surfaces is not significant because the areas of orthographic projections of both the first side surfaces and the second side surfaces on the back surface are relatively small due to relatively large angles, to ensure that the back surface of the back contact solar cell has relatively high light utilization. In addition, it can also prevent such a phenomenon that a depth of the surfaces of the spacer regions 16 that are recessed toward the interior of the silicon substrate 11 relative to the surfaces of the second regions 15 is relatively small due to relatively small angles, to ensure that after the second doped semiconductor layer 13 deposited as a whole layer is selectively etched, the portions of the second doped semiconductor layer 13 located in the spacer regions 16 and on the first doped semiconductor layer 12 are completely removed to prevent electric leakage, and ensure that the back contact solar cell has relatively high electrical reliability.

In addition, the first side surfaces and the second side surfaces are also textured surfaces. Specifically, a morphology of textured structures on the first side surfaces and a morphology of textured structures the second side surfaces are both approximately the same as a morphology of the textured structures on the bottom surfaces of the spacer regions 16. Alternatively, as shown in FIG. 5 to FIG. 12, the morphology of the textured structures on the first side surfaces and the morphology of the textured structures on the second side surfaces are both different from the morphology of the textured structures on the bottom surfaces of the spacer regions 16. Referring to FIG. 3 to FIG. 12, the bottom surfaces of the spacer regions 16 are approximately parallel to the horizontal plane. In addition, since the surfaces of the spacer regions 16 are recessed toward the interior of the silicon substrate 11 relative to the surfaces of the second regions 15, the first side surfaces of the spacer regions 16 close to the first regions 14 and the second side surfaces of the spacer regions 16 close to the second regions 15 are respectively obliquely disposed or vertically disposed relative to the horizontal plane. It can be seen that a relative positional relationship between the bottom surfaces of the spacer regions 16 and the horizontal plane is different from relative positional relationships respectively between the first side surfaces and the horizontal plane, and between the second side surfaces and the horizontal plane. Therefore, a surface crystal orientation of the bottom surfaces of the spacer regions 16 is different from a surface crystal orientation of the first side surfaces and a surface crystal orientation of the second side surfaces respectively. It can be understood that performing texturing treatment on the surfaces to form textured structures is implemented based on different etching rates of an etching agent on portions of the silicon substrate 11 in different crystal orientations. Therefore, when the surface crystal orientation of the bottom surfaces of the spacer regions 16 is different respectively from the surface crystal orientation of the first side surfaces and the surface crystal orientation of the second side surfaces, a morphology of the textured structures formed on the first side surfaces and a morphology of the textured structures formed on the second side surfaces by using the etching agent are both different from the morphology of the textured structures formed on the bottom surfaces of the spacer regions 16. In this case, in the back contact solar cell provided in the embodiment of the present application, in a case that the morphology of the textured structures on the first side surfaces and the morphology of the textured structures on the second side surfaces are both different from the morphology of the textured structures on the bottom surfaces of the spacer regions 16, an additional operation does not need to be performed to form textured structures having approximately the same morphology on the bottom surfaces, the first side surfaces, and the second side surfaces of the spacer regions 16, thereby helping simplify the manufacturing process of the back contact solar cell while lowering the manufacturing difficulty of the back contact solar cell.

Specifically, in a case that the morphology of the textured structures on the first side surfaces and the morphology of the textured structures on the second side surfaces are different from the morphology of the textured structures on the bottom surfaces of the spacer regions, the morphology of the textured structures on the first side surfaces and the morphology of the textured structures on the second side surfaces can be determined based on the angles respectively between the first side surfaces and the horizontal plane and between the second side surfaces and the horizontal plane, and an actual manufacturing process. This is not specifically limited herein.

For example, as shown in FIG. 4 to FIG. 8, a longitudinal cross section of the first side surfaces and a longitudinal cross section of the second side surfaces are zigzag-shaped. Specifically, the longitudinal cross sections are longitudinal cross sections extending in an arrangement direction of the first regions and the second regions. For example, FIG. 4 is a schematic partial diagram of a longitudinal cross section of the back contact solar cell. In this case, a zigzag shape has a plurality of sharp-corner morphologies. Based on this, in a case that other factors are the same, compared with a smoothly transitional morphology such as an arc shape or a curve, the zigzag morphology has a relatively high coarseness. Therefore, when the longitudinal cross section of the first side surfaces and the longitudinal cross section of the second side surfaces are zigzag-shaped, it helps cause the first side surfaces and the second side surfaces to have relatively high coarseness, thereby further helping further reduce the reflectivity of the first side surfaces and the reflectivity of the second side surfaces and further enhance the light utilization of the back contact solar cell.

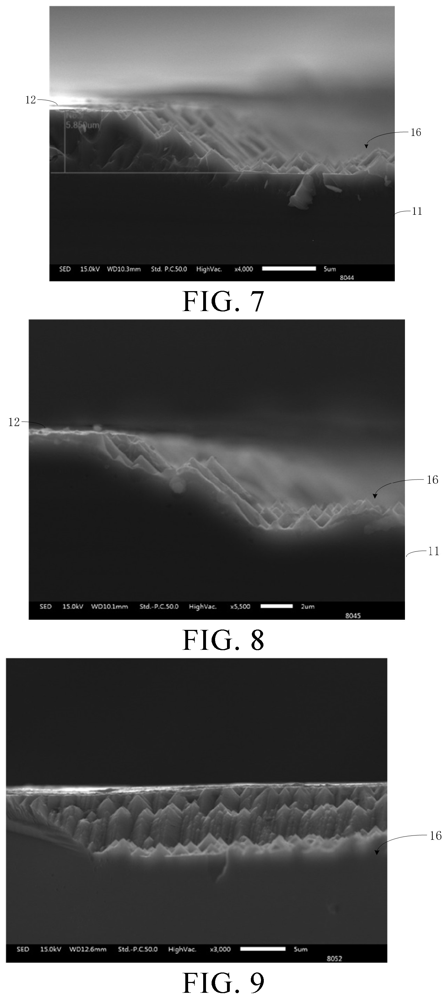

For example, as shown in FIG. 9 to FIG. 12, the textured structures on the first side surfaces and the textured structures on the second side surfaces are triangular-prism-like structures. A beneficial effect in this case is similar to the beneficial effect when the longitudinal cross section of the first side surfaces and the longitudinal cross section of the second side surfaces are zigzag-shaped, and details are not described herein again. In addition, the triangular-prism-like structure is a polyhedral structure, which helps enlarge a specific surface area of the first side surfaces and a specific surface area of the second side surfaces, and further reduces the reflectivity of the first side surfaces and the reflectivity of the second side surfaces.

For the first doped semiconductor layer 12 and the second doped semiconductor layer 13, in terms of material, a material of the first doped semiconductor layer 12 or a material of the second doped semiconductor layer 13 can be a semiconductor material such as silicon, silicon germanium, germanium, or gallium arsenide. In terms of arrangement of substances, a crystal phase of the first doped semiconductor layer 12 or a crystal phase of the second doped semiconductor layer 13 can be amorphous, microcrystalline, nanocrystalline, monocrystalline, polycrystalline, or the like. In terms of conductivity type, the conductivity type of the first doped semiconductor layer 12 or the conductivity type of the second doped semiconductor layer 13 can be opposite to the conductivity type of the silicon substrate 11, or can be the same as the conductivity type of the silicon substrate 11, as long as it ensures that the conductivity type of the first doped semiconductor layer 12 and the conductivity type of the second doped semiconductor layer 13 are opposite to each other. A thickness of the first doping semiconductor layers 12 and a thickness of the second doped semiconductor layer 13 can be set based on an actual need. This is not specifically limited herein. For example, the thickness of the first doping semiconductor layers 12 or the thickness of the second doped semiconductor layer 13 is greater than or equal to 100 nm and less than or equal to 500 nm.

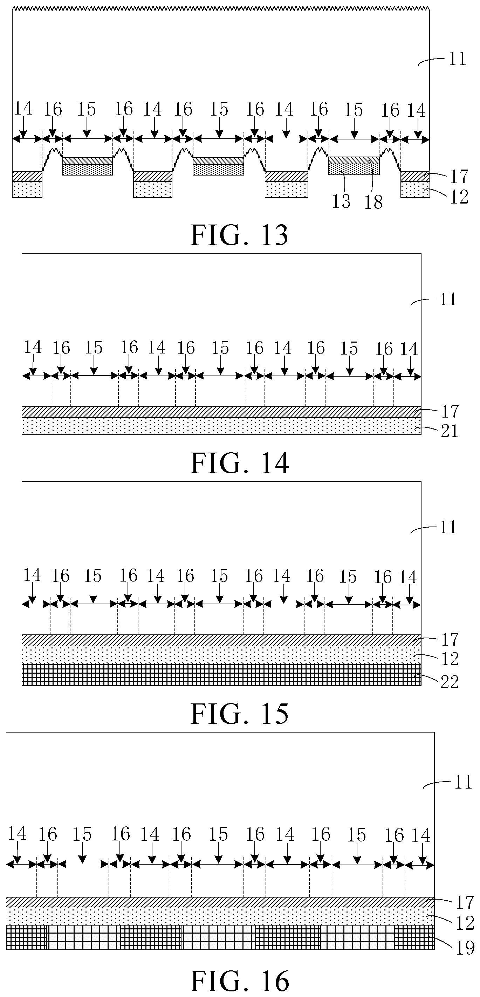

In an actual application process, as shown in FIG. 3, the first doped semiconductor layer 12 are directly formed in the first regions 14 of the silicon substrate 11. Alternatively, as shown in FIG. 13, the back contact solar cell further includes a first passivation layer 17 located between the silicon substrate 11 and the first doped semiconductor layer 12. In this case, the first passivation layer 17 and the first doped semiconductor layer 12 can constitute selective contact structures, to implement chemical passivation on the first regions 14 of the back surface of the silicon substrate 11 and implement selective collection on the carriers having the corresponding conductivity types, thereby reducing the carrier recombination rate on the back surface and helping enhance the photoelectric conversion efficiency of the back contact solar cell.

Specifically, a material of the first passivation layer 17 is determined based on the material of the first doped semiconductor layer 12 and a type of the selective contact structure formed by the first passivation layer 17 and the first doped semiconductor layer 12 in an actual application scenario. This is not specifically limited herein.

For example, when the selective contact structure formed by the first passivation layer 17 and the first doped semiconductor layer 12 is a tunneling passivation contact structure, the first doped semiconductor layer 12 are doped polysilicon layers, and the first passivation layer 17 is a tunneling passivation layer. A material of the tunneling passivation layer includes silicon oxide, aluminum oxide, titanium oxide, or other materials.

For another example, when the selective contact structure formed by the first passivation layer 17 and the first doped semiconductor layer 12 is a heterogeneous contact structure, the first doped semiconductor layer 12 are doped amorphous silicon layers and/or doped microcrystalline silicon layers, and the first passivation layer 17 is an intrinsic amorphous silicon layer and/or an intrinsic microcrystalline silicon layer.

A thickness of the first passivation layer 17 is set based on an actual need. This is not specifically limited herein. For example, the thickness of the first passivation layer 17 is greater than or equal to 0.5 nm and less than or equal to 3 nm.

With regard to the second doped semiconductor layer 13, as shown in FIG. 3, the second doped semiconductor layer 13 are directly formed in the second regions 15 of the silicon substrate 11. Alternatively, as shown in FIG. 13, the back contact solar cell further includes a second passivation layer 18 located between the silicon substrate 11 and the second doped semiconductor layer 13. In this case, the second passivation layer 18 and the second doped semiconductor layer 13 can constitute selective contact structures, to implement chemical passivation on the second regions 15 of the back surface of the silicon substrate 11 and implement selective collection on the carriers having the corresponding conductivity types, thereby reducing the carrier recombination rate on the back surface and helping enhance the photoelectric conversion efficiency of the back contact solar cell.

Specifically, for a material and a thickness of the second passivation layer 18, refer to the material and the thickness of the first passivation layer 17 as described above. They are not elaborated herein again.

According to a second aspect, an embodiment of the present application provides a manufacturing method for a back contact solar cell. The following describes a manufacturing process with reference to cross-sectional views of operations shown in FIG. 14 to FIG. 27. Specifically, the manufacturing method for the back contact solar cell includes the following steps.

First, a silicon substrate is provided. A back surface of the silicon substrate has first regions and second regions that are alternately spaced apart from each other, and spacer regions located between the first regions and the second regions adjacent to the first regions.

Specifically, for the ranges of the first regions, the second regions, and the spacer regions on the back surface, refer to the foregoing descriptions, and they are not elaborated herein again.

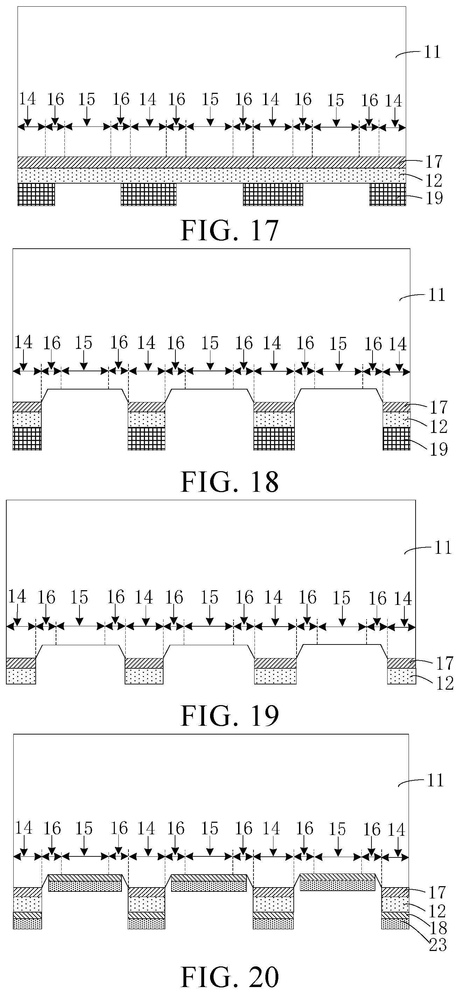

Next, as shown in FIG. 19, first doped semiconductor layer 12 are formed in the first regions 14. In addition, surfaces of the first spacer regions 15 and surfaces of the second regions 16 are recessed toward an interior of the silicon substrate 11 relative to surfaces of the first regions 14.

In an actual manufacturing process, as shown in FIG. 17, after the silicon substrate 11 is provided, the first doped semiconductor layer 12 disposed as a whole layer and first mask layer 19 located on portions of the first doped semiconductor layer 12 corresponding to the first regions 14 are formed on the back surface of the silicon substrate 11. Next, as shown in FIG. 18, portions of the first doped semiconductor layer 12 located in the spacer regions 16 and the second regions 15 are selectively removed under a masking action of the first mask layer 19. Surfaces of the spacer regions 16 and surfaces of the second regions 15 are recessed toward the interior of the silicon substrate 11 relative to surfaces of the first regions 14.

For a material and a thickness of the first doped semiconductor layer 12, and a depth of the surfaces of both the spacer regions 16 and the second regions 15 that are recessed toward the interior of the silicon substrate 11 after the operation, refer to the foregoing descriptions. For the first mask layer, a material of the first mask layer may be any material having a masking function. This is not specifically limited herein. In addition, a formation process and a specific formation procedure of the first doped semiconductor layer 12 and the first mask layer 19 can be determined based on specific materials of the first doped semiconductor layer 12 and the first mask layer 19.

For example, in a case that the material of the first doped semiconductor layer 12 includes silicon, that the first doped semiconductor layer 12 disposed as a whole layer and first mask layer 19 located on portions of the first doped semiconductor layer 12 corresponding to the first regions 14 are formed on the back surface of the silicon substrate 11 includes the following steps. As shown in FIG. 14, first intrinsic semiconductor layers 21 disposed as a whole layer are formed on the back surface of the silicon substrate 11. Next, as shown in FIG. 15, doping treatment is performed on the first intrinsic semiconductor layers 21, to form the first intrinsic semiconductor layers 21 as the first doped semiconductor layer 12 and form, on the first doped semiconductor layer 12, a first doped silica glass layer 22 disposed as a whole layer. Later, as shown in FIG. 16, heat treatment is performed by using a laser etching process on portions of the first doped silica glass layer corresponding to the spacer regions 16 and the second regions 15, to convert a portion of the first doped silica glass layer 22 that is not subjected to the heat treatment as the first mask layer 19. Then, as shown in FIG. 17, a portion of the first doped silica glass layer 22 that is subjected to the heat treatment is removed.

Specifically, when the material of the first doped semiconductor layer 12 includes the silicon, the material of the first doped semiconductor layer 12 only includes the silicon. Alternatively, the material of the first doped semiconductor layer 12 includes both the silicon and other semiconductor materials such as silicon germanium. In addition, in an actual manufacturing process, the first intrinsic semiconductor layers 21 disposed on the back surface as a whole layer is formed through by using a process such as chemical vapor deposition. Next, the doping treatment is performed on the first intrinsic semiconductor layers 21 by using a process such as diffusion. After the doping treatment, the first doped semiconductor layer 12 can be obtained, and the first doped silica glass layer 22 disposed as a whole layer can be further formed on the first doped semiconductor layer 12. Then, the heat treatment is performed on a portion of the first doped silica glass layer 22 by using the laser etching process. In this case, as shown in FIG. 16, the compactness of the portion of the first doped silica glass layer 22 that is subjected to laser treatment is reduced, so that the portion is easily removed. The compactness of a portion of the first doped silica glass layer 22 that is not subjected to laser treatment is relatively high, so that the portion is hardly removed. Thus, after the heat treatment, different portions of the first doped silica glass layer 22 have different etching selectivity ratios, and the first mask layer 19 for performing patterning treatment on the first doped semiconductor layer 12 are obtained, instead of additionally forming other mask materials and forming other mask deposition procedures to obtain the first mask layer 19. It helps reduce the manufacturing costs of the back contact solar cell and simplify the manufacturing flow of the back contact solar cell. A specific condition of the laser etching process can be set based on an actual application scenario. This is not specifically limited herein.

For example, laser used in the laser etching process is a nanosecond laser, a picosecond laser, a femtosecond laser, or the like. The laser etching process is greater than or equal to 10 W and less than or equal to 100 W. A diameter of a laser spot is greater than or equal to 50 µm and less than or equal to 300 µm.

Certainly, in a case that the material of the first doped semiconductor layer 12 includes silicon or the material of the first doped semiconductor layer 12 does not include silicon, the first doped semiconductor layer 12 disposed on the back surface as a whole layer can be formed by using a process such as chemical vapor deposition and doping. Then, a first mask layer 19 is formed, the material of which includes silicon nitride or other materials that have a masking function.

In addition, after the first mask layer 19 are formed, a wet chemical process can be used to selectively remove, under the masking action of the first mask layer 19, the portions of the first doped semiconductor layer 12 located in the spacer regions 16 and the second regions 15. In addition, the surfaces of the spacer regions 16 and the surfaces of the second regions 15 are recessed toward the interior of the silicon substrate 11 relative to the surfaces of the first regions 14, to prevent damage to the silicon substrate 11 caused by high-temperature laser, thereby helping enhancing the yield of the back contact solar cell. Specifically, a process condition of selectively etching the first doped semiconductor layer 12 can be determined based on a used etching process, the material of the first doped semiconductor layer 12, and the depth of the surfaces of both the spacer region 16 and the second region 15 that are recessed toward the interior of the silicon substrate 11 after the operation, and the like. This is not specifically limited herein.

For example, when the portions of the first doped semiconductor layer 12 located in the spacer regions 16 and the second regions 15 are selectively removed by using the wet chemical process under the masking action of the first mask layer 19, and the surfaces of the spacer regions 16 and the surfaces of the second regions 15 are recessed toward the interior of the silicon substrate 11 relative to the surfaces of the first regions 14, a process temperature of the wet chemical process is greater than or equal to 60°C and less than or equal to 85°C. In addition, process duration of the wet chemical process is greater than 40 s and less than or equal to 300 s. In addition, a wet chemical etching solution used in the wet chemical process is an alkaline wet chemical etching solution, and a volume ratio of an alkaline component (such as NaOH or KOH) in the alkaline wet chemical etching solution is greater than or equal to 2% and less than or equal to 20%. For example, the process temperature of the wet chemical process is 60°C, 70°C, 75°C, 78°C, 80°C, or the like. The process duration of the wet chemical process is 40 s, 80 s, 100 s, 150 s, 200 s, 260 s, 300 s, or the like. When the wet chemical etching solution used in the wet chemical process is the alkaline wet chemical etching solution, the volume ratio of the alkaline component in the alkaline wet chemical etching solution is 2%, 3%, 6%, 9%, 12%, 15%, 20%, or the like. In this case, the process temperature and the process duration of the wet chemical process can affect the depth of the surfaces of both the second regions 15 and the spacer regions 16 that are recessed toward the interior of the silicon substrate 11 relative to the surfaces of the first regions 14 through the wet chemical process. Based on this, when the process temperature of the wet chemical process is within the foregoing range, it can prevent such a phenomenon that the depth of the surfaces of both the second regions 15 and the spacer regions 16 that are recessed toward the interior of the silicon substrate 11 relative to the surfaces of the first regions 14 are relatively small because of a relatively small process temperature. In addition, it can also prevent such a phenomenon that the depth of the surfaces of both the second regions 15 and the spacer regions 16 that are recessed toward the interior of the silicon substrate 11 relative to the surfaces of the first regions 14 are relatively large because of a relatively large process temperature. For a beneficial effect of prevention of the relatively small and large depths of the surfaces of both the second regions 15 and the spacer regions 16 that are recessed toward the interior of the silicon substrate 11 relative to the surfaces of the first regions 14, refer to the above description. In addition, a beneficial effect of the process duration and the volume ratio of the alkali component being within the foregoing ranges is similar to the beneficial effect of the process temperature being greater than or equal to 60°C and less than or equal to 85°C, and details are not described herein.

In addition, the flatness of the surfaces of both the spacer regions 16 and the second regions 15 after the operation can also be enhanced in a manner of adding a polishing additive into the wet chemical etching solution. This helps enhance the forming quality of the second doped semiconductor layer 12 and the forming quality of the textured structures formed on the surfaces of the spacer regions 16, and ensures that the textured structures formed on the surfaces of the spacer regions 16 are uniformly distributed, so that the portions of the spacer regions 16 have a good light trapping effect. Specifically, a component of the polishing additive and a ratio of the polishing additive to the wet chemical etching solution can be determined based on an actual application scenario. This is not specifically limited herein. For example, the polishing additive includes sodium benzoate, a defoaming agent, a surfactant, and the like. A volume ratio of the polishing additive in the wet chemical etching solution is greater than or equal to 0.5% and less than or equal to 5%.

It should be noted that when the manufactured back contact solar cell further includes a first passivation layer located between the first regions and the first doped semiconductor layer, in the manufacturing method for the back contact solar cell, after the silicon substrate is provided, and before the first doped semiconductor layer is formed in the first regions, the manufacturing method further includes the following steps. The first passivation layer is first formed in the first regions by using a deposition and etching process.

Alternatively, as shown in FIG. 14, after the silicon substrate 11 is provided, the first passivation layer 17 disposed on the back surface as a whole layer is formed by using a process such as chemical vapor deposition. Then, as shown in FIG. 17 and FIG. 18, after the first mask layer 19 are formed and the first doped semiconductor layer 12 are selectively etched under the masking action of the first mask layer 19, the first passivation layer 17 is selectively etched. In this case, it is unnecessary to additionally form corresponding mask layers to form the first passivation layer 17. This simplifies the manufacturing process of the back contact solar cell.

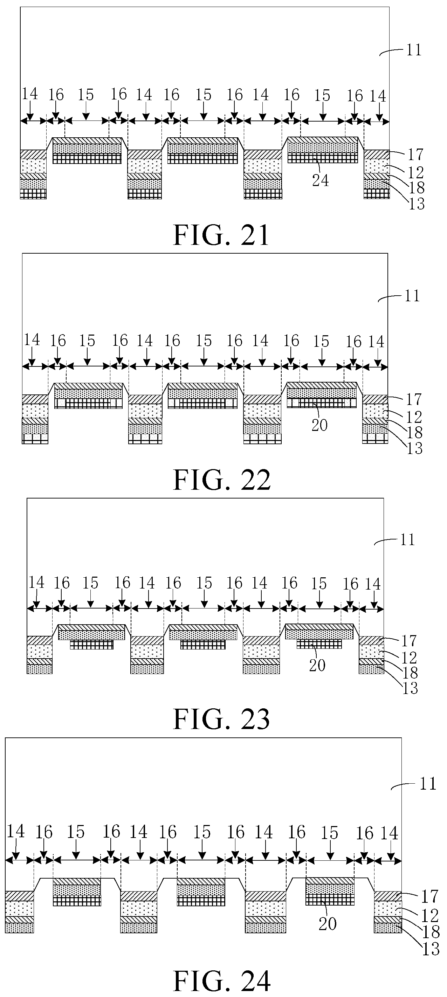

Later, as shown in FIG. 24, second doped semiconductor layer 13 are formed in the second regions 15. A conductivity type of the second doped semiconductor layer 13 is opposite to that of the first doped semiconductor layer 12.

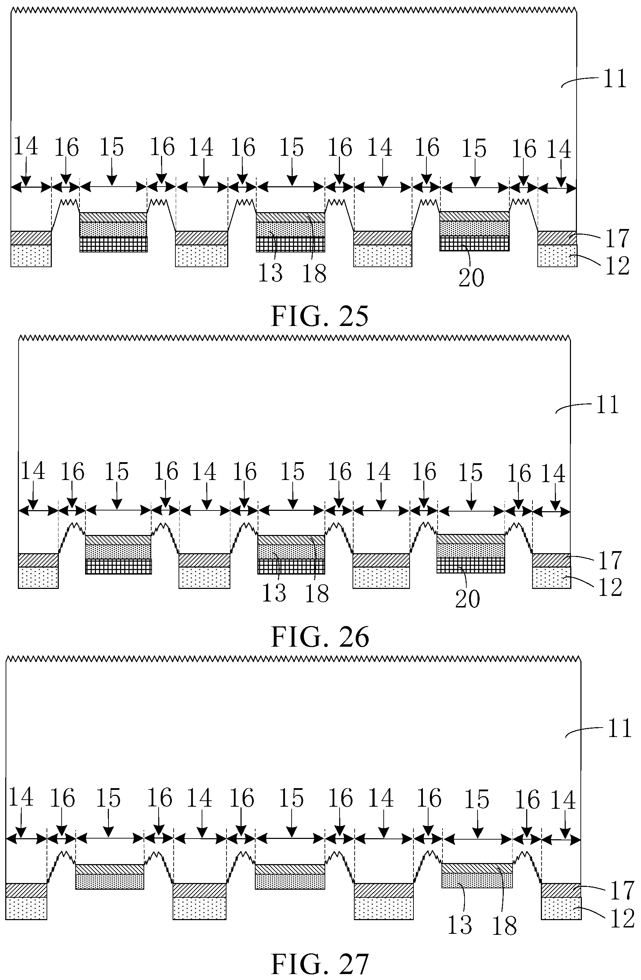

In an actual manufacturing process, as shown in FIG. 23, after the surfaces of the second regions 15 and the surfaces of the spacer regions 16 are recessed toward the interior of the silicon substrate 11 relative to the surfaces of the first regions 14, the second doped semiconductor layer 13 are disposed on the first doped semiconductor layer 12 and in the spacer regions 16 and the second regions 15. In addition, a second mask layer 20 is formed on portions of the second doped semiconductor layer 13 corresponding to the second regions 15. Next, as shown in FIG. 25 to FIG. 26, portions of the second doped semiconductor layer 13 corresponding to the first regions 14 and the spacer regions 16 are selectively removed under a masking action of the second mask layer 20.

Specifically, for a material and a thickness of the second doped semiconductor layer 13, a depth of the surfaces of the spacer regions 16 that are recessed toward the interior of the silicon substrate 11 after the operation, refer to the foregoing descriptions. They are not elaborated herein again. A material of the second mask layer 20 is any material having a masking function. In an actual manufacturing process, a formation process and a specific formation procedure of the second doped semiconductor layer 13 and the second mask layer 20 can be determined based on materials of the second doped semiconductor layer 13 and the second mask layer 20.

For example, in a case that the material of the second doped semiconductor layer include silicon, the second doped semiconductor layer is deposited on the first doped semiconductor layer and in the spacer regions and the second regions. That a second mask layer is formed on portions of the second doped semiconductor layer corresponding to the second regions includes the following steps: As shown in FIG. 20, second intrinsic semiconductor layers 23 are formed on the first doped semiconductor layer 12 and in the spacer regions 16 and the second regions 15. Next, as shown in FIG. 21, doping treatment is performed on the second intrinsic semiconductor layers 23, to form the second intrinsic semiconductor layers 23 as the second doped semiconductor layer 13 and form, on the second doped semiconductor layer 13, a second doped silica glass layer 24 disposed as a whole layer. Later, as shown in FIG. 22, heat treatment is performed on portions of the second doped silica glass layer 24 corresponding to the first regions 14 and the spacer regions 16, to form portions of the second doped silica glass layer 24 corresponding to the second regions 15 as the second mask layer 20. Then, as shown in FIG. 23, portions of the second doped silica glass layer 24 that are subjected to the heat treatment are removed.

Specifically, when the material of the second doped semiconductor layer 13 includes the silicon, the material of the second doped semiconductor layer 13 only includes the silicon. Alternatively, the material of the second doped semiconductor layer 13 includes both the silicon and other semiconductor materials such as silicon germanium. In addition, in an actual manufacturing process, the second intrinsic semiconductor layers 23 disposed on the back surface as a whole layer is formed through by using a process such as chemical vapor deposition. Next, the doping treatment is performed on the second intrinsic semiconductor layers 23 by using a process such as diffusion. After the doping treatment, the second doped semiconductor layer 13 can be obtained, and the second doped silica glass layer 24 disposed as a whole layer can be further formed on the second doped semiconductor layer 13. Then, the heat treatment is performed on the portions of the second doped silica glass layer 24 corresponding to the first regions 14 and the spacer regions 16 by using a laser etching process. In this case, as shown in FIG. 22, the compactness of the portions of the second doped silica glass layer 24 that are subjected to laser treatment is reduced, so that the portions are easily removed. The portions of the second doped silica glass layer corresponding to the second regions 15 are not subjected to laser treatment. In this case, the compactness of the portions of the second doped silica glass layer 24 corresponding to the second regions 15 is relatively high, so that the portions are hardly removed. Thus, after the heat treatment, different portions of the second doped silica glass layer 24 have different etching selectivity ratios, and the second mask layer 20 for performing patterning treatment on the second doped semiconductor layer 13 are obtained, instead of additionally forming other mask materials and forming other mask deposition procedures to obtain the second mask layer 20. It helps reduce the manufacturing costs of the back contact solar cell and simplify the manufacturing flow of the back contact solar cell.

A specific condition of the laser etching process can be set based on an actual application scenario. This is not specifically limited herein. For example, laser used in the laser etching process is a nanosecond laser, a picosecond laser, a femtosecond laser, or the like. The laser etching process is greater than or equal to 10 W and less than or equal to 100 W. A diameter of a laser spot is greater than or equal to 50 µm and less than or equal to 350 µm.

Certainly, in a case that the material of the second doped semiconductor layer 13 includes silicon or the material of the second doped semiconductor layer 13 does not include silicon, the second doped semiconductor layer 13 disposed on the back surface as a whole layer can be formed by using a process such as chemical vapor deposition and doping. Then, A second mask layer 20 is formed, the material of which includes silicon nitride or other materials that have a masking function.

In addition, after the second mask layer 20 are formed, a wet chemical process can be used to selectively remove, under the masking action of the second mask layer 20, the portions of the second doped semiconductor layer 13 located in the spacer regions 16 and the first doped semiconductor layer 14. In addition, the surfaces of the spacer regions 16 are recessed toward the interior of the silicon substrate 11 relative to the surfaces of the second regions 15, to prevent damage to the silicon substrate 11 caused by high-temperature laser, thereby helping enhancing the yield of the back contact solar cell. Specifically, a process condition of selectively etching the second doped semiconductor layer 13 can be determined based on a used etching process, the material of the second doped semiconductor layer 13, and the depth of the surfaces of the spacer region 16 that are recessed toward the interior of the silicon substrate 11, and the like. This is not specifically limited herein.

Then, as shown in FIG. 27, the surfaces of the spacer regions 16 are recessed toward the interior of the silicon substrate relative to the surfaces of the second regions 15, and texturing treatment is performed on bottom surfaces of the spacer regions 16, first side surfaces of the spacer regions 16 close to the first regions 14, and second side surfaces of the spacer regions 16 close to the second regions 15, to form the bottom surfaces, the first side surfaces, and the second side surfaces of the spacer regions 16 as textured surfaces.

In an actual manufacturing process, as shown in FIG. 24 to FIG. 26, in the process of forming the second doped semiconductor layer 13, if the second mask layer is formed, the surfaces of the spacer regions 16 are continued to be recessed toward the interior of the silicon substrate relative to the surfaces of the second regions 15 under the masking action of the second mask layer, and the foregoing texturing treatment is performed on the bottom surfaces of the spacer regions 16, the first side surfaces of the spacer regions 16 close to the first regions 14, and the second side surfaces of the spacer regions 16 close to the second regions 15.

Specifically, a specific process of the foregoing texturing treatment can be determined based on morphologies of textured structures on the bottom surfaces, the first side surfaces, and the second side surfaces of the spacer regions 16. For example, as shown in FIG. 25, after the portions of the second doped semiconductor layer 13 located on the first doped semiconductor layer 12 and in the spacer regions 16 are completely removed, first texturing treatment is performed on the bottom surfaces of the spacer regions 16, to form pre-formed textured structures on the bottom surfaces of the spacer regions 16. Then, as shown in FIG. 26, second texturing treatment is performed on the bottom surfaces, the first side surfaces, and the second side surfaces of the spacer regions 16, to adjust a morphology of the pre-formed textured structures, and the first side surfaces and the second side surfaces are converted into the textured surfaces. In this case, the first texturing treatment is first performed on the bottom surfaces of the spacer regions 16, to convert the bottom surfaces of the spacer regions 16 into the pre-formed textured structures. Meanwhile, the second texturing treatment is continued to be performed on the bottom surfaces, the first side surfaces, and the second side surfaces of the spacer regions 16, to ensure that the morphology of the pre-formed textured structures can be adjusted while the first side surfaces and the second side surfaces are converted into the textured surfaces, thereby ensuring that the surfaces of the spacer regions 16 have relatively low reflectivity. This further increases the amount of light absorbed by the back surface of the back contact solar cell and enhances the photoelectric conversion efficiency of the back contact solar cell.

Specifically, For the morphology and size of the pre-formed textured structures formed by the first texturing treatment on the bottom surfaces of the spacer regions 16, refer to the morphology and size of the textured structures on the bottom surfaces of the spacer regions 16 in the manufactured back contact solar cell.

For example, as shown in FIG. 25, the pre-formed textured structures are pyramid-like structures. In this case, when the foregoing pre-formed textured structures are the pyramid-like structures, the textured structures on the bottom surfaces of the spacer regions 16 can have a pyramid-like morphology after the second texturing treatment, thereby further enlarging a specific surface area of the bottom surfaces of the spacer regions 16 and reducing the reflectivity of the bottom surfaces.

For example, a height of the pre-formed textured structures is greater than or equal to 0.5 µm and less than or equal to 3 µm. For example, the height of the pre-formed textured structures is 0.5 µm, 1 µm, 1.5 µm, 2 µm, 2.5 µm, 3 µm, or the like. In this case, if the height of the pre-formed textured structures is within the foregoing range, it can prevent such a phenomenon that the specific surface area of the bottom surfaces of the spacer regions 16 is relatively small because the height of the pre-formed textured structures is relatively small, and it can ensure that the bottom surfaces of the spacer regions 16 have relatively low reflectivity. In addition, it can also prevent such a phenomenon that portions of the spacer regions 16 corresponding to the silicon substrate 11 have a relatively large etching depth because the depth of the bottom surfaces of the spacer regions 16 that need to be recessed toward the interior of the silicon substrate 11 relative to the surfaces of the second regions 15 is relatively large due to a relatively large height of the pre-formed textured structures, thereby helping implement thinning production. In addition, in a case that the pre-formed textured structures are the pyramid-like structures, the height of the pre-formed textured structures is within the foregoing range, so that it can also prevent a small number of pre-formed textured structures formed on the bottom surfaces of the spacer regions 16 due to a relatively large overall size of the pre-formed textured structures because of the relatively large height of the pre-formed textured structures, thereby ensuring that the surfaces of the spacer regions have a good light trapping effect after the second texturing treatment.

In addition, the conditions of the first texturing treatment and the second texturing treatment are not specifically limited in the embodiment of the present application, as long as the pre-formed textured structures having a corresponding morphology can be formed on the bottom surfaces of the spacer regions 16 after the first texturing treatment, and the bottom surfaces, the first side surfaces, and the second side surfaces of the spacer regions 16 can be converted, after the second texturing treatment, into textured structures meeting a corresponding morphology requirement.

Specifically, the wet chemical etching solution used in the second texturing treatment includes a texturing additive, to ensure that after the second texturing treatment, the first side surfaces and the second side surfaces are converted into the textured surfaces, to reduce the reflectivity of the first side surfaces and the reflectivity of the second side surfaces. A type of the texturing additive and a volume ratio of the texturing additive in the wet chemical etching solution can be determined based on a size of the textured structures and an actual application scenario. For example, the texturing additive includes sodium benzoate, a defoaming agent, a surfactant, and the like.

For example, the volume ratio of the texturing additive in the wet chemical etching solution is greater than or equal to 0.01% and less than or equal to 5%. For example, the volume ratio of the texturing additive in the wet chemical etching solution is 0.01%, 0.5%, 1%, 2%, 3%, 4%, 5%, or the like. In this case, if the volume ratio of the texturing additive in the wet chemical etching solution is within the foregoing range, it can prevent a relatively small size of the textured structures formed on and/or a relatively small number of textured structures formed on both the first side surfaces and the second side surfaces after the second texturing treatment due to a relatively small volume ratio, thereby ensuring that the first side surfaces and the second side surfaces have relatively high surface coarseness after the second texturing treatment. It can also prevent a relatively large amplitude of adjustment on the morphology of the textured structures, formed based on the pre-formed textured structures, on the bottom surfaces of the spacer regions after the second texturing treatment due to a relatively large volume ratio, thereby ensuring that the surfaces of the spacer regions have a good light trapping effect.

For example, a treatment temperature of the second texturing treatment is greater than or equal to 50°C and less than or equal to 85°C. In addition, treatment duration of the second texturing treatment is greater than or equal to 30 s and less than or equal to 240 s. For example, the treatment temperature of the second texturing treatment is 50°C, 55°C, 60°C, 65°C, 70°C, 75°C, 80°C, 85°C, or the like. In addition, the treatment duration of the second texturing treatment is 30 s, 50 s, 100 s, 150 s, 200 s, 240 s, or the like. In this case, both the treatment temperature and the treatment duration of the second texturing treatment affect a size of the textured structures formed on the bottom surfaces, the first side surfaces, and the second side surfaces of the spacer regions through the second texturing treatment. Based on this, when the treatment temperature of the second texturing treatment is within the foregoing range, it can prevent a relatively small size of the textured structures due to a relatively small treatment temperature. In addition, it can also prevent a relatively large size of the textured structures due to a relatively large treatment temperature. For a beneficial effect of prevention of the relatively small and large sizes of the textured structures, refer to the above description. In addition, a beneficial effect of the treatment duration being within the foregoing range is similar to the beneficial effect of the treatment temperature being greater than or equal to 50°C and less than or equal to 85°C, and details are not described herein.

It should be noted that when the manufactured back contact solar cell further includes a second passivation layer located between the second regions and the second doped semiconductor layer, in the manufacturing method for the back contact solar cell, after the surfaces of both the spacer regions and the second regions are recessed toward the interior of the silicon substrate relative to the surfaces of the first regions, before the second doped semiconductor layer is formed in portions of the second regions, the manufacturing method further includes the following steps. The second passivation layer is first formed in the second regions by using a deposition and etching process.

Alternatively, as shown in FIG. 20, after the surfaces of the spacer regions 16 and the surfaces of the second regions 15 are recessed toward the interior of the silicon substrate 11 relative to the surfaces of the first regions 14, and before the second doped semiconductor layer 13 are formed in the portions of the second regions 15, the second passivation layer 18 can be deposited on the first doped semiconductor layer 12 and in the second regions 15 and the spacer regions 16 by using a process such as chemical vapor deposition. Then, as shown in FIG. 23 and FIG. 24, after the second mask layer 20 are formed and the second doped semiconductor layer 13 are selectively etched under the masking action of the second mask layer 20, the second passivation layer 18 is selectively etched. In this case, it is unnecessary to additionally form corresponding mask layers to form the second passivation layer 18. This simplifies the manufacturing process of the back contact solar cell.

In addition, in a proper process, alignment marks are formed on the first doped semiconductor layer 12 and/or the second doped semiconductor layer 13. For example, after the first doped semiconductor layer 12 and/or the second doped semiconductor layer 13 are formed, the alignment marks are formed on the first doped semiconductor layer 12 and/or the second doped semiconductor layer 13 by using a laser process.

For beneficial effects of the second aspect and various implementations of the second aspect in the embodiments of the present application, refer to the analysis of the beneficial effects of the first aspect and various implementations of the first aspect, and details are not described herein.

In the foregoing descriptions, technical details such as patterning and etching of the layers are not described in detail. However, a person skilled in the art should understand that a layer, a region, and the like of a required shape may be formed by using various technical means. In addition, to form the same structure, a person skilled in the art can further design a method that is not completely the same as the method described above. In addition, although the foregoing describes the embodiments separately, it does not mean that measures in the embodiments cannot be favorably combined.

The embodiments of the present application are described above. However, the embodiments are merely for illustrative purposes and are not intended to limit the scope of the present application. The scope of the present application is defined by the appended claims and equivalents thereof. A person skilled in the art may make various substitutes and modifications without departing from the scope of the present application, and the substitutes and modifications shall fall within the scope of the present application.

## Claims

1. A back contact solar cell, comprising: a silicon substrate, and a first doped semiconductor layer and a second doped semiconductor layer that are alternately distributed in a spaced manner on a back surface of the silicon substrate, wherein
a conductivity type of the first doped semiconductor layer is opposite to a conductivity type of the second doped semiconductor layer; on the back surface of the silicon substrate, regions corresponding to the first doped semiconductor layer are first regions, regions corresponding to the second doped semiconductor layer are second regions, and regions between the first regions and second regions adjacent to the first regions are spacer regions; surfaces of the second regions are recessed toward an interior of the silicon substrate relative to surfaces of the first regions; surfaces of the spacer regions are recessed toward the interior of the silicon substrate relative to the surfaces of the second regions; and bottom surfaces of the spacer regions, first side surfaces of the spacer regions close to the first regions, and second side surfaces of the spacer regions close to the second regions are textured surfaces.[ 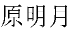 1]

2. The back contact solar cell according to claim 1, wherein the first side surfaces and the second side surfaces are obliquely disposed relative to a horizontal plane, so that a cross-sectional area of the spacer regions gradually increases in a direction from a light receiving surface to the back surface; and/or
angles between the first side surfaces of the spacer regions and the horizontal plane are greater than or equal to 52° and less than or equal to 58°, and angles between the second side surfaces of the spacer regions and the horizontal plane are greater than or equal to 52° and less than or equal to 58°; and/or
a morphology of textured structures on the first side surfaces and a morphology of textured structures on the second side surfaces are both different from a morphology of textured structures on the bottom surfaces of the spacer regions.

3. The back contact solar cell according to claim 1 or 2, wherein a longitudinal cross section of the first side surfaces and a longitudinal cross section of the second side surfaces are zigzag-shaped; and/or
the textured structures on the first side surfaces and the textured structures on the second side surfaces are triangular-prism-like structures[ 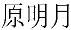 2].

4. The back contact solar cell according to claim 1 or 2, wherein the textured structures on the bottom surfaces of the spacer regions are pyramid-like structures[ 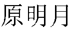 3].

5. The back contact solar cell according to claim 1, wherein a depth of the surfaces of the second regions that are recessed toward the interior of the silicon substrate relative to the surfaces of the first regions is greater than or equal to 0.5 µm and less than or equal to 3 µm; and/or
a depth of the bottom surfaces of the spacer regions that are recessed toward the interior of the silicon substrate relative to the surfaces of the first regions is greater than or equal to 2.5 µm and less than or equal to 9 µm.

6. The back contact solar cell according to claim 1, wherein the back contact solar cell further comprises a first passivation layer located between the silicon substrate and the first doped semiconductor layer;
and/or
the back contact solar cell further comprises a second passivation layer located between the silicon substrate and the second doped semiconductor layer; and/or
the surfaces of the first regions and/or the second regions are flat surfaces.

7. The back contact solar cell according to claim 1, wherein the back contact solar cell further comprises alignment marks [ 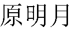 4][ 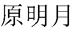 5] located on the first doped semiconductor layer and/or the second doped semiconductor layer.

8. A manufacturing method for a back contact solar cell, comprising:
providing a silicon substrate; wherein a back surface of the silicon substrate has first regions and second regions that are alternately spaced apart from each other, and spacer regions located between the first regions and the second regions;
forming a first doped semiconductor layer in the first regions, and recessing surfaces of the second regions and surfaces of the spacer regions toward an interior of the silicon substrate relative to surfaces of the first regions;
forming a second doped semiconductor layer in the second regions; wherein a conductivity type of the second doped semiconductor layer is opposite to a conductivity type of the first doped semiconductor layer; and
recessing the surfaces of the spacer regions toward the interior of the silicon substrate relative to the surfaces of the second regions, and performing texturing treatment on bottom surfaces of the spacer regions, first side surfaces of the spacer regions close to the first regions, and second side surfaces of the spacer regions close to the second regions, to convert the bottom surfaces, the first side surfaces, and the second side surfaces of the spacer regions into textured surfaces.

9. The manufacturing method for the back contact solar cell according to claim 8, wherein the performing texturing treatment on bottom surfaces of the spacer regions, first side surfaces of the spacer regions close to the first regions, and second side surfaces of the spacer regions close to the second regions comprises:
performing first texturing treatment on the bottom surfaces of the spacer regions, to convert the bottom surfaces of the spacer regions into pre-formed textured structures; and
performing second texturing treatment on the bottom surfaces, the first side surfaces, and the second side surfaces of the spacer regions, to adjust a morphology of the pre-formed textured structures, and converting the first side surfaces and the second side surfaces into the textured surfaces.

10. The manufacturing method for the back contact solar cell according to claim 9, wherein the pre-formed textured structures are pyramid-like structures; and/or, a height of the pre-formed textured structures is greater than or equal to 0.5 µm and less than or equal to 3 µm; and/or
a wet chemical etching solution used in the second texturing treatment comprises a texturing additive, and a volume ratio of the texturing additive in the wet chemical etching solution is greater than or equal to 0.01% and less than or equal to 5%; and/or, a treatment temperature of the second texturing treatment is greater than or equal to 50°C and less than or equal to 85°C; and/or, treatment duration of the second texturing treatment is greater than or equal to 30 s and less than or equal to 240 s.

11. The manufacturing method for the back contact solar cell according to claim 8, wherein the forming a first doped semiconductor layer in the first regions, and recessing surfaces of the second regions and surfaces of the spacer regions toward an interior of the silicon substrate relative to surfaces of the first regions comprises: forming, on the back surface of the silicon substrate, a first doped semiconductor layer disposed as a whole layer and a first mask layer located on portions of the first doped semiconductor layer corresponding to the first regions; next, selectively removing portions of the first doped semiconductor layer located in the spacer regions and the second regions under a masking action of the first mask layer; and recessing the surfaces of the spacer regions and the surfaces of the second regions toward the interior of the silicon substrate relative to the surfaces of the first regions; and/or
the manufacturing method for the back contact solar cell comprises: after the recessing the surfaces of the second regions and the surfaces of the spacer regions toward the interior of the silicon substrate relative to the surfaces of the first regions, performing the following steps: depositing a second doped semiconductor layer on the first doped semiconductor layer and in the spacer regions and the second regions; forming a second mask layer on portions of the second doped semiconductor layer corresponding to the second regions; next, selectively removing portions of the second doped semiconductor layer corresponding to the first regions and the spacer regions under a masking action of the second mask layer; and recessing the surfaces of the spacer regions toward the interior of the silicon substrate relative to the surfaces of the second regions, and performing the texturing treatment on the bottom surfaces of the spacer regions, the first side surfaces of the spacer regions close to the first regions, and the second side surfaces of the spacer regions close to the second regions.

12. The manufacturing method for the back contact solar cell according to claim 11, wherein a material of the first doped semiconductor layer comprises silicon; and
the forming, on the back surface of the silicon substrate, first doped semiconductor layer disposed as a whole layer and a first mask layer located on portions of the first doped semiconductor layer corresponding to the first regions comprises:
forming, on the back surface of the silicon substrate, a first intrinsic semiconductor layer disposed as a whole layer;
performing doping treatment on the first intrinsic semiconductor layers, to convert the first intrinsic semiconductor layers into the first doped semiconductor layer and form, on the first doped semiconductor layer, a first doped silica glass layer disposed as a whole layer;
performing heat treatment on portions of the first doped silica glass layer corresponding to the spacer regions and the second regions, to convert a portion of the first doped silica glass layer that is not subjected to the heat treatment into the first mask layer; and
removing a portion of the first doped silica glass layer that is subjected to the heat treatment.

13. The manufacturing method for the back contact solar cell according to claim 11, wherein the portions of the first doped semiconductor layer located in the spacer regions and the second regions are selectively removed under the masking action of the first mask layer by using a wet chemical process; the surfaces of the spacer regions and the surfaces of the second regions are recessed toward the interior of the silicon substrate relative to the surfaces of the first regions; wherein
a process temperature of the wet chemical process is greater than or equal to 60°C and less than or equal to 85°C; and/or, process duration of the wet chemical process is greater than or equal to 40 s and less than or equal to 300 s; and/or, a wet chemical etching solution used in the wet chemical process is an alkaline wet chemical etching solution, and a volume ratio of an alkaline component in the alkaline wet chemical etching solution is greater than or equal to 2% and less than or equal to 20%; and/or, the wet chemical etching solution used in the wet chemical process comprises a polishing additive, and a volume ratio of the polishing additive in the wet chemical etching solution is greater than or equal to 0.5% and less than or equal to 5%.

14. The manufacturing method for the back contact solar cell according to claim 11, wherein a material of the second doped semiconductor layer comprises silicon;
the second doped semiconductor layer is deposited on the first doped semiconductor layer and in the spacer regions and the second regions; and the forming a second mask layer on portions of the second doped semiconductor layer corresponding to the second regions comprises:
depositing second intrinsic semiconductor layers on the first doped semiconductor layer and in the spacer regions and the second regions; and
performing doping treatment on the second intrinsic semiconductor layers, to convert the second intrinsic semiconductor layers into the second doped semiconductor layer and form, on the second doped semiconductor layer, a second doped silica glass layer disposed as a whole layer;
performing heat treatment on portions of the second doped silica glass layer corresponding to the first regions and the spacer regions, to convert portions of the second doped silica glass layer corresponding to the second regions into the second mask layer; and
removing a portion of the second doped silica glass layer that is subjected to the heat treatment.

15. The manufacturing method for the back contact solar cell according to any one of claims 8 to 14, wherein the manufacturing method for the back contact solar cell further comprises: forming a first passivation layer in the first regions before the forming the first doped semiconductor layer in the first regions; and/or
the manufacturing method for the back contact solar cell further comprises: forming a second passivation layer in the second regions before the forming the second doped semiconductor layer in portions of the second regions.

16. The manufacturing method for the back contact solar cell according to any one of claims 8 to 14, further comprising: forming alignment marks on the first doped semiconductor layer and/or the second doped semiconductor layer.
